# EUROPEAN PATENT SPECIFICATION

(11) **EP 1 872 394 B1**
(45) Date of publication and mention of the grant of the patent: **11.04.2012**
(21) Application number: 06732251.1
(22) Date of filing: 18.04.2006
(51) Int. Cl.: H01L 21/00, B24B 9/00

(54) **SUBSTRATE PROCESSING APPARATUS**
SUBSTRATVERARBEITUNGSVORRICHTUNG
APPAREIL DE TRAITEMENT DE SUBSTRAT

(30) Priority: 19.04.2005 JP 2005121680
(43) Date of publication of application: 02.01.2008
(73) Proprietor: EBARA CORPORATION, Ohta-ku, Tokyo 144-8510 (JP)
(72) Inventor: TAKAHASHI, Tamami c/o Ebara Corporation, Tokyo 1448510 (JP); SHIRAKASHI, Mitsuhiko c/o Ebara Corporation, Tokyo 1448510 (JP); ITO, Kenya c/o Ebara Corporation, Tokyo 1448510 (JP); INOUE, Kazuyuki c/o Ebara Corporation, Tokyo 1448510 (JP); YAMAGUCHI, Kenji c/o Ebara Corporation, Tokyo 1448510 (JP); SEKI, Masaya c/o Ebara Corporation, Tokyo 1448510 (JP)
(74) Representative: Wagner, Karl H.
(86) International application number: PCT/JP2006/308493
(87) International publication number: WO 2006/112532

(56) References cited:
- EP-A2- 1 291 132
- JP-A- 01 071 656
- JP-A- 2000 158 309
- JP-A- 2003 163 188
- US-A1- 2004 185 751

## Description

### Technical Field

The present invention relates to a substrate processing apparatus, and more particularly to a substrate processing apparatus having a polishing unit for polishing a peripheral portion of a substrate such as a semiconductor wafer.

### Background Art

In recent years, according to finer structures and higher integration of semiconductor devices, it has become more important to manage particles. One of the major problems in managing particles is dust caused by surface roughness produced at a peripheral portion (a bevel portion and an edge portion) of a substrate, such as a semiconductor wafer, in a manufacturing process of semiconductor devices.

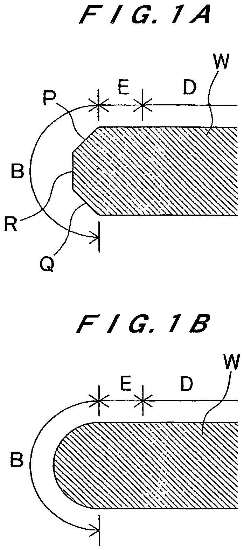

FIGS. 1A and 1B are enlarged cross-sectional views showing examples of a peripheral portion of a wafer W. FIG. 1A shows a peripheral portion of a straight-type wafer W having a cross-section formed by a plurality of straight lines. FIG. 1B shows a peripheral portion of a round-type wafer W having a cross-section formed by a curve. In FIG. 1A, a bevel portion B of the wafer W includes an upper inclined portion P and a lower inclined portion Q, which are inclined with respect to upper and lower surfaces of an outer circumferential portion of the wafer W, respectively, and a side surface R of the outer circumferential portion of the wafer W. In FIG. 1B, a bevel portion B of the wafer W includes a portion having a curvature in a cross-section of an outer circumferential portion of the wafer W. In FIGS. 1A and 1B, an edge portion of the wafer W includes an area E located between an inner boundary of the bevel portion B and an upper surface D of the wafer W, on which semiconductor devices are formed. In the following description, a peripheral portion of a wafer includes the aforementioned bevel portion B and edge portion E.

Further, in the following description, a notch means a V-shaped incision (V-shaped notch) or a linear incision (orientation flat) formed in an outer circumferential portion of a silicon wafer or the like for indicating an orientation of the wafer. The notch is provided at a peripheral portion of a wafer. Specifically, the notch is formed in a recessed manner at a peripheral portion of a wafer.

There has heretofore been known a polishing apparatus (peripheral portion polishing apparatus) for polishing a peripheral portion of a wafer. Such a polishing apparatus has been used for shaping an outer circumferential portion of a wafer prior to a formation process of semiconductor devices. Recently, such a polishing apparatus has been used for removing films as a pollution source attached to a peripheral portion of a wafer in a formation process of semiconductor devices or for removing surface roughness produced at a peripheral portion of a wafer, for example, for separating needle projections formed after formation of deep trenches in the wafer. When objects attached to a peripheral portion of a wafer are removed in advance, it is possible to prevent contamination of wafers, which would be caused by a transfer robot for holding and transferring wafers. Further, when surface roughness is removed in advance from a peripheral portion of a wafer, it is possible to prevent dust from being produced by separation of objects formed on the peripheral portion of the wafer.

Further, there has practically been used a substrate processing apparatus having process units including a polishing apparatus (polishing unit) for polishing a peripheral portion of a wafer, a cleaning unit for cleaning the wafer, and a drying unit for drying the wafer. This substrate processing apparatus is employed to perform a sequence of processes on a wafer which include polishing a peripheral portion of the wafer. According to such a substrate processing apparatus; it is possible to perform a sequence of processes, including polishing a peripheral portion of a wafer and cleaning and drying the polished wafer, all at once in a single substrate processing apparatus. Thus, such a substrate processing apparatus has an excellent efficiency.

Meanwhile, a polishing unit provided in a substrate processing apparatus includes a bevel polishing device for polishing a bevel portion of a wafer or a notch polishing device for polishing a notch of a wafer. The bevel polishing device or the notch polishing device is arranged in the polishing unit so as to surround a wafer to be polished. In order to improve an efficiency of a polishing process in such a substrate processing apparatus, it is necessary to properly arrange the polishing unit. For example, a plurality of polishing units having the above structure should be provided in a substrate processing apparatus.

Further, in a case of a conventional substrate processing apparatus having a plurality of polishing units, an arrangement of the polishing units is determined in consideration of a space required for a transfer robot to transfer a wafer to or from the respective polishing units and spaces required for the polishing units. Thus, no attention is paid to the accessibility of an operator to bevel polishing devices or notch polishing devices in the polishing units when the operator replaces polishing tapes or polishing pads. Accordingly, the operator has to work with a poor efficiency. In order to resolve such drawbacks, it is desirable to arrange the substrate processing apparatus such that an operator can efficiently conduct replacement of expendable parts, such as polishing tapes and polishing pads in the polishing units, and maintenance of respective components.

Further, if a polishing liquid such as slurry or abrasive particles scatter at the time of polishing by a polishing unit, the polishing liquid or the abrasive particles may contaminate respective portions in the polishing unit or a polished wafer to cause further contamination of other areas to which the polished wafer is transferred. In such a case, it is necessary to frequently clean units such as a polishing unit and a transferring unit in the substrate processing apparatus. Thus, maintenance operation becomes a heavy load on an operator. Additionally, the operator has to have access to the polishing unit or other units to conduct cleaning. Accordingly, an operational efficiency is decreased. In order to reduce loads of maintenance operation, it is desirable that contamination of portions of the polishing unit and a wafer is prevented at the time of polishing.

US 2004/0185 751 relates to a substrate processing apparatus having a single polishing unit having inter alia a bevel polishing device and a notch polishing device. EP 1 291 132 A1 relates to a semiconductor wafer polishing apparatus having two polishing units.

### Disclosure of Invention

In accordance with the present invention, a substrate processing apparatus as set forth in claim 1 is provided. Further embodiments of the invention are claimed in the dependent claims.

The present invention has been made in view of the above drawbacks. It is, therefore, a first object of the present invention to provide a substrate processing apparatus which has an improved process efficiency of polishing a substrate, allows maintenance operation to be efficiently conducted in a short time of period, and can reduce loads of maintenance operation.

A second object of the present invention is to provide a substrate polishing method which can improve a process efficiency of polishing a substrate, allows maintenance operation to be efficiently conducted in a short time of period, and can reduce loads of maintenance operation.

A third object of the present invention is to provide a substrate processing method which can improve a process efficiency of polishing a substrate, allows maintenance operation to be efficiently conducted in a short time of period, and can reduce loads of maintenance operation.

According to a first aspect of the present invention, there is provided a substrate processing apparatus having at least two polishing units for polishing a peripheral portion of a substrate, such as a semiconductor wafer, which is suitable for removing surface roughness produced at a peripheral portion of a substrate or films as a pollution source attached to a peripheral portion of a substrate. Each of the two polishing units includes a bevel polishing device and/or a notch polishing device for polishing a peripheral portion of a substrate. The substrate processing apparatus has a maintenance space formed between the two polishing units. The bevel polishing device and/or the notch polishing device in each of the two polishing units faces the maintenance space so as to be accessible from the maintenance space.

Each of the two polishing unit may be housed in a casing having a hatch provided at a position facing the maintenance space. The bevel polishing device and/or the notch polishing device in each of the two polishing units may be accessible from the maintenance space by opening the hatch.

With the above arrangement, an operator is accessible to the bevel polishing devices and/or the notch polishing devices in the two polishing units from the same space without moving the bevel polishing device and/or the notch polishing device in each of the polishing units. Accordingly, it is possible to efficiently conduct maintenance operation of the bevel polishing devices and/or the notch polishing devices in the polishing units in a short time of period. As a result, convenience of maintenance for the substrate processing apparatus can be improved.

Thus, an arrangement of the units in the substrate processing apparatus and an arrangement of components in the units are designed to improve a process efficiency of polishing a substrate. The operator is accessible to the units from a common space to efficiently conduct maintenance operation in a short time of period. Further, it is possible to prevent contamination of the units and the substrate during polishing so as to reduce loads of maintenance operation.

The bevel polishing device may include a polishing tape, a bevel polishing head for pressing the polishing tape against the peripheral portion of the substrate, and a polishing tape supply/recovery mechanism for supplying the polishing tape to the bevel polishing head and recovering the polishing tape from the bevel polishing head. The polishing tape in the polishing tape supply/recovery mechanism may be adapted to be replaced from the maintenance space. The notch polishing device may include a polishing tape, a notch polishing head for pressing the polishing tape against a notch of the substrate, and a polishing tape supply/recovery mechanism for supplying the polishing tape to the notch polishing head and recovering the polishing tape from the notch polishing head. The polishing tape in the polishing tape supply/recovery mechanism may be adapted to be replaced from the maintenance space.

With the above arrangement, since the polishing tape can be replaced from the maintenance space, the maintenance operation can be conducted efficiently from the exterior of the polishing units in a short time of period. Accordingly, convenience of maintenance for the substrate processing apparatus can be improved.

The casing may have sidewalls on four sides thereof. One of the bevel polishing device and the notch polishing device may be disposed near a first of the sidewalls of the casing. The first of the sidewalls of the casing faces the maintenance space. Another of the bevel polishing device and the notch polishing device may be disposed near a second of the sidewalls of the casing which is adjacent to the first of the sidewalls of the casing. The second of the sidewalls of the casing faces a housing for the substrate processing apparatus.

With the above arrangement, useless spaces can be eliminated in the polishing units. Further, the bevel polishing device or the notch polishing device is accessible from the maintenance space or the housing for the substrate processing apparatus which is adjacent to the maintenance space. Accordingly, it is possible to efficiently conduct maintenance operation in a short period of time.

The casing may have a hatch provided in the second of the sidewalls thereof. The housing for the substrate processing apparatus may have a door provided at a position facing the second of the sidewalls of the casing. The substrate processing apparatus may be configured such that the bevel polishing device or the notch polishing device is accessible from an exterior of the substrate processing apparatus when the door of the housing and the hatch of the casing are opened.

With the above arrangement, it is possible to conduct maintenance operation such as replacement of the polishing tape of the bevel polishing device or the notch polishing device in the polishing unit directly from the exterior of the substrate processing apparatus. Accordingly, the maintenance operation can efficiently be conducted in a short period of time. As a result, convenience of maintenance for the substrate processing apparatus can be improved.

The substrate processing apparatus may further include a transfer device for transferring the substrate to and from the polishing units. An opening for introducing the substrate into the polishing unit may be formed in a third of the sidewalls of the casing. The opening faces the transfer device. A shutter is provided for opening and closing the opening. With the above arrangement, the substrate can efficiently be transferred so as to improve a throughput of the substrate processing apparatus.

The bevel polishing devices or the notch polishing devices in the polishing units may be arranged so as to be symmetrical with interposing the maintenance space therebetween. Operations of the bevel polishing devices or the notch polishing devices in the polishing units may be configured so as to be symmetrical with interposing the maintenance space therebetween.

When the bevel polishing devices or the notch polishing devices in the polishing units are arranged so as to be symmetrical with interposing the maintenance space therebetween, it is possible to facilitate maintenance operation of the bevel polishing devices or the notch polishing devices in the polishing units. Accordingly, it is possible to efficiently conduct maintenance operation in a short period of time. When operations of the bevel polishing devices or the notch polishing devices in the polishing units are configured so as to be symmetrical with interposing the maintenance space therebetween, operation of the transfer device to transfer the substrate to and from the polishing units and positioning of substrates can be designed so as to be symmetrical with interposing the maintenance space therebetween. Thus, operation of the transfer device to transfer the substrate to and from the polishing units and operations in the polishing units can be performed smoothly. Further, useless spaces for operations of the bevel polishing devices or the notch polishing devices in the polishing units can be eliminated so as to operate the polishing units efficiently.

The polishing unit may include a substrate holding table for holding the substrate to be polished by the bevel polishing device and/or the notch polishing device. The polishing unit may further include a swing mechanism for swinging the substrate holding table on a horizontal plane and/or a horizontal movement mechanism for linearly moving the substrate holding table on a horizontal plane.

With the above arrangement, the substrate held by the substrate holding table can be swung or linearly moved by the substrate holding table swing mechanism or the substrate holding table horizontal movement mechanism while the substrate is polished by the bevel polishing device and/or the notch polishing device. Accordingly, desired polishing can be conducted on the peripheral portion of the substrate. Further, the substrate can be moved from the bevel polishing device to the notch polishing device by moving the substrate holding table. Accordingly, it is possible to facilitate polishing by the bevel polishing device and the notch polishing device.

The bevel polishing device and/or the notch polishing device may be configured so as to bring a surface of a polishing tape into sliding contact with the peripheral portion or a notch of the substrate to polish the substrate. The polishing tape may have a polishing layer in which a chemically inactive resin material into which abrasive particles are dispersed is applied to a surface of a tape base.

With the above arrangement, it is possible to prevent chemical reaction with the polishing liquid. Accordingly, it is possible to prevent abrasive particles from being attached to the substrate so as to contaminate the substrate and from scattering and being attached to the components of the polishing units so as to contaminate the components. Thus, it is possible to reduce loads of maintenance operation such as cleaning of the polishing units and the substrate processing apparatus. Further, it is possible to prevent degradation of quality of the substrate.

The polishing unit may include a substrate holding device for horizontally holding the substrate to be polished by the bevel polishing device and/or the notch polishing device. The polishing unit may further include a first supply nozzle for supplying at least one of pure water, ultrapure water, and deionized water toward a polishing area of the substrate held by the substrate holding device and a second supply nozzle for supplying at least one of pure water, ultrapure water, and deionized water toward a central portion on an upper surface of the substrate.

With the above arrangement, pure water supplied from the second supply nozzle spreads over an upper surface of the substrate held horizontally to form a film of pure water on the upper surface of the substrate. Thus, the substrate is prevented from being contaminated by an atmosphere or polishing wastes in the polishing units. Further, it is also possible to prevent secondary contamination in a unit to which the contaminated substrate is to be transferred. Accordingly, it is possible to reduce loads of maintenance operation such as cleaning of the substrate processing apparatus. Further, while pure water is supplied near the polishing area of the substrate from the first supply nozzle, pure water supplied from the second supply nozzle spreads over the upper surface of the substrate to reach the vicinity of the polishing area. Accordingly, polishing wastes are prevented from scattering from the polishing area, and frictional heat can be removed during polishing. Since pure water is supplied to the substrate from the first and second supply nozzles, it is possible to maintain a cleanliness of the substrate and the components in the polishing units. Further, since pure water is supplied from the first and second supply nozzles, frictional heat can be removed between the polishing layer and the substrate. Accordingly, it is possible to prevent the resin material from being softened so as to cause abrasive particles to be separated from the polishing tape.

According to a second aspect of the present invention, there is provided a substrate polishing method which can improve a process efficiency of polishing a substrate, allows maintenance operation to be efficiently conducted in a short time of period, and can reduce loads of maintenance operation. According to this method, abrasive particles are dispersed into a chemically inactive resin material. The chemically inactive resin material is applied to a surface of a tape base to form a polishing tape having a polishing layer. A surface of the polishing layer of the polishing tape is brought into sliding contact with a peripheral portion of the substrate to polish the substrate.

According to the above method, it is possible to prevent abrasive particles from being separated from the polishing tape due to a chemical reaction with the polishing liquid during polishing. Accordingly, it is possible to prevent abrasive particles from being attached to the substrate so as to contaminate the substrate and from scattering and being attached to the components of the polishing units so as to contaminate the components. Thus, it is possible to reduce loads of maintenance operation such as cleaning of the polishing units and the substrate processing apparatus. Further, it is possible to prevent degradation of quality of the substrate.

The substrate may have semiconductor devices formed on a surface thereof and a number of recesses formed in the surface thereof. In this case, since it is possible to prevent abrasive particles from being separated from the polishing tape due to a chemical reaction with the polishing liquid during polishing, abrasive particles are not introduced into the recesses in the substrate. Accordingly, it is possible to prevent degradation of quality of the substrate.

Only pure water may be supplied to the substrate during the polishing. In this case, it is possible to maintain a cleanliness of the substrate and the units in the apparatus and to prevent secondary contamination in a unit to which the contaminated substrate is to be transferred. Further, since the resin material of the tape base is not reformed by a chemical reaction, abrasive particles are prevented from being separated. Accordingly, it is possible to prevent abrasive particles from being attached to the substrate so as to contaminate the substrate and from scattering and being attached to the units of the apparatus so as to contaminate the components. Thus, it is possible to reduce loads of maintenance operation such as cleaning of the substrate processing apparatus. Further, since pure water is supplied during polishing, frictional heat can be removed between the polishing layer and the substrate. Accordingly, it is possible to prevent the resin material from being softened so as to cause abrasive particles to be separated from the polishing tape.

According to a third aspect of the present invention, there is provided a substrate polishing method which can improve a process efficiency of polishing a substrate, allows maintenance operation to be efficiently conducted in a short time of period, and can reduce loads of maintenance operation. According to this method, a substrate is moved to one of a bevel polishing device for polishing a peripheral portion of the substrate and a notch polishing device for polishing a notch of the substrate by a movement mechanism. The peripheral portion of the substrate or the notch of the substrate is first polished by the one of the bevel polishing device and the notch polishing device. Only pure water is supplied to the substrate to form a water film covering a surface of the substrate after the polishing. The substrate is moved to another of the bevel polishing device and the notch polishing device by the movement mechanism in a state such that the water film is formed on the surface of the substrate. The peripheral portion of the substrate or the notch of the substrate is second polished by the other of the bevel polishing device and the notch polishing device.

According to the above method, the substrate is prevented from being contaminated by an atmosphere or polishing wastes in the polishing units. It is possible to maintain a cleanliness of the substrate. Further, it is possible to prevent secondary contamination of the bevel polishing device or the notch polishing device where the substrate is to be transferred. Therefore, polishing can be conducted without hindrance in the bevel polishing device or the notch polishing device. Since it is also possible to maintain a cleanliness of the components in the polishing units, loads of maintenance operation such as cleaning can be reduced.

According to a fourth aspect of the present invention, there is provided a substrate processing method which can improve a process efficiency of polishing a substrate, allows maintenance operation to be efficiently conducted in a short time of period, and can reduce loads of maintenance operation. This method employs a substrate processing apparatus having at least two polishing units and a transfer device for transferring the substrate into the polishing units. Each of the polishing units includes at least one of a bevel polishing device for polishing a peripheral portion of the substrate and a notch polishing device for polishing a notch of the substrate. Bevel polishing devices or notch polishing devices are arranged in the polishing units so as to be symmetrical as seen from the transfer device. Different substrates are transferred into the polishing units by the transfer device. The different substrates are polished in parallel in the polishing units to remove contaminants and/or surface roughness of peripheral portions of the different substrates. In this case, the bevel polishing devices or the notch polishing devices may be operated in the polishing units so as to be symmetrical as seen from the transfer device.

According to the above method, a plurality of substrates are simultaneously polished so as to increase the number of substrates processed per unit time. Thus, a throughput of the substrate processing apparatus 1 can be improved. Further, with the above arrangement, even if different substrates are transferred into the respective polishing units by the transfer device and polished in parallel in the respective polishing units, the substrates can smoothly be transferred to the respective polishing units, and bevel polishing or notch polishing can smoothly be conducted in the polishing units. Further, useless spaces for operation of the bevel polishing device or the notch polishing device can be eliminated in the polishing units to operate the polishing units efficiently.

According to a fifth aspect of the present invention, there is provided a substrate processing method which can improve a process efficiency of polishing a substrate, allows maintenance operation to be efficiently conducted in a short time of period, and can reduce loads of maintenance operation. This method employs a substrate processing apparatus having at least two polishing units and a transfer device for transferring the substrate into the polishing units. Each of the polishing units includes at least one of a bevel polishing device for polishing a peripheral portion of the substrate and a notch polishing device for polishing a notch of the substrate. Bevel polishing devices or notch polishing devices are arranged in the polishing units so as to be symmetrical as seen from the transfer device. A substrate is transferred sequentially into the polishing units by the transfer device. The substrate is sequentially polished in the polishing units to remove contaminants and/or surface roughness of peripheral portions of the substrate. In this case, the bevel polishing devices or the notch polishing devices may be operated in the polishing units so as to be symmetrical as seen from the transfer device.

According to the above method, the respective polishing units can perform different polishing processes, e.g., rough polishing and finish polishing. Thus, the polishing units can be used for the respective purposes. Therefore, the substrate can effectively be finished into a desired shape. Further, with the above arrangement, even if the same substrate is transferred sequentially into the polishing units and polished in the polishing units, the substrate can smoothly be transferred to the respective polishing units, and bevel polishing or notch polishing can smoothly be conducted in the polishing units. Further, useless spaces for operation of the bevel polishing device or the notch polishing device can be eliminated in the polishing units to operate the polishing units efficiently.

According to a sixth aspect of the present invention, there is provided a substrate processing method which can improve a process efficiency of polishing a substrate, allows maintenance operation to be efficiently conducted in a short time of period, and can reduce loads of maintenance operation. This method employs a substrate processing apparatus having at least two polishing units and a transfer device for transferring the substrate into the polishing units. Each of the polishing units includes at least one of a bevel polishing device for polishing a peripheral portion of the substrate and a notch polishing device for polishing a notch of the substrate. Bevel polishing devices or notch polishing devices are arranged in the polishing units so as to be symmetrical as seen from the transfer device. One of the following two polishing processes is selectively performed. In a first polishing process, different substrates are transferred into the polishing units by the transfer device and polished in parallel in the polishing units to remove contaminants and/or surface roughness of peripheral portions of the different substrates. In a second polishing process, a substrate is transferred sequentially into the polishing units by the transfer device and polished sequentially in the polishing units to remove contaminants and/or surface roughness of peripheral portions of the substrate. In this case, the bevel polishing devices or the notch polishing devices may be operated in the polishing units so as to be symmetrical as seen from the transfer device.

According to purposes of substrate processing, the number of substrates processed per unit time can be increased to improve a throughput of the substrate processing apparatus. Alternatively, the polishing units can be used for the respective purposes so that the substrate can effectively be finished into a desired shape. When one of these processes is selectively performed, it is not necessary to rearrange the units and operations of the substrate processing apparatus so as to correspond to the selected process. Thus, the above processes can be switched with a simple procedure to improve an efficiency of the substrate. Further, in each process, the substrate can smoothly be transferred to the respective polishing units, and bevel polishing or notch polishing can smoothly be conducted in the polishing units.

The above and other objects, features, and advantages of the present invention will be apparent from the following description when taken in conjunction with the accompanying drawings which illustrate preferred embodiments of the present invention by way of example.

### Brief Description of Drawings

FIG. 1A is a cross-sectional view showing a peripheral portion of a straight-type wafer;
FIG. 1B is a cross-sectional view showing a peripheral portion of a round-type wafer;
FIG. 2 is a schematic plan view showing a substrate processing apparatus according to an embodiment of the present invention;
FIG. 3A is a front view showing an example of a loading/unloading port in the substrate processing apparatus shown in FIG. 2;
FIG. 3B is a side view of FIG. 3A;
FIG. 4 is a schematic view showing another example of the loading/unloading port in the substrate processing apparatus shown in FIG. 2;
FIG. 5 is a schematic side view showing a first transfer robot in the substrate processing apparatus shown in FIG. 2;
FIG. 6 is a perspective view schematically showing a second transfer robot in the substrate processing apparatus shown in FIG. 2;
FIG. 7 is a perspective view schematically showing an example of a measurement unit in the substrate processing apparatus shown in FIG. 2;
FIG. 8A is a schematic plan view of the measurement unit shown in FIG. 7;
FIG. 8B is a side view of FIG. 8A;
FIG. 9A is a perspective view schematically showing a substrate holding and rotating mechanism of the measurement unit shown in FIG. 7;
FIG. 9B is a schematic plan view of the substrate holding and rotating mechanism shown in FIG. 9A;
FIG. 10A is a schematic view showing the substrate holding and rotating mechanism which holds a wafer by an upper chuck;
FIG. 10B is a schematic view showing the substrate holding and rotating mechanism which holds a wafer by a lower chuck;
FIG. 11 is a perspective view showing an example in which a measurement unit and a wafer stage are both installed in the substrate processing apparatus shown in FIG. 2;
FIG. 12 is a schematic plan view showing a polishing unit according to a first embodiment of the present invention;
FIG. 13 is a cross-sectional side view of FIG. 12;
FIG. 14 is a cross-sectional side view taken along a direction perpendicular to the cross-section of FIG. 13;
FIG. 15 is an enlarged plan view schematically showing a bevel polishing device in the polishing unit shown in FIG. 12;
FIGS. 16A through 16C are schematic views explanatory of operation of a bevel polishing head in the bevel polishing device shown in FIG. 15;
FIG. 17 is an enlarged plan view schematically showing a notch polishing device in the polishing unit shown in FIG. 12;
FIG. 18 is a schematic side view showing a notch polishing head in the notch polishing device shown in FIG. 17;
FIGS. 19A through 19C are schematic views explanatory of operation of the notch polishing head shown in FIG. 18;
FIG. 20 is a schematic side view showing an example of a polishing endpoint detection device in the polishing unit;
FIG. 21 is a schematic side view showing another example of a polishing endpoint detection device in the polishing unit;
FIG. 22A is a schematic side view showing another example of the polishing endpoint detection device;
FIG. 22B is an enlarged view schematically showing a photosensor in the polishing endpoint detection device shown in FIG. 22A;
FIG. 23 is a schematic plan view showing a polishing unit according to a second embodiment of the present invention;
FIG. 24 is a cross-sectional side view schematically showing a portion of the polishing unit shown in FIG. 23;
FIG. 25 is a schematic side view of a bevel polishing device in the polishing unit shown in FIG. 23;
FIG. 26 is a partial enlarged view showing a bevel polishing head in the bevel polishing device shown in FIG. 25;
FIG. 27A is schematic view showing the bevel polishing head shown in FIG. 26 at the time of polishing;
FIG. 27B is a view as seen from a direction X of FIG. 27A;
FIG. 28 is a schematic side view showing a notch polishing device in the polishing unit shown in FIG. 23;
FIG. 29 is a schematic side view showing a drive mechanism in the notch polishing device shown in FIG. 28;
FIG. 30A is a view as seen from a direction Y of FIG. 29;
FIG. 30B is a side view of an elastic roller in the notch polishing device shown in FIG. 28;
FIGS. 31A through 31C are schematic views showing a relationship between the notch polishing device and a wafer during polishing of a notch of the wafer;
FIG. 32 is a schematic plan view showing another arrangement of the polishing units in the substrate processing apparatus shown in FIG. 2;
FIG. 33 is a perspective view schematically showing a primary cleaning unit in the substrate processing apparatus shown in FIG. 2;
FIG. 34 is a perspective view schematically showing a spin-dry unit having a cleaning function in the substrate processing apparatus shown in FIG. 2;
FIG. 35 is a diagram explanatory of routes of wafers in several process patterns; and
FIG. 36 is a diagram explanatory of routes of wafers in several process patterns.

### Best Mode for Carrying Out the Invention

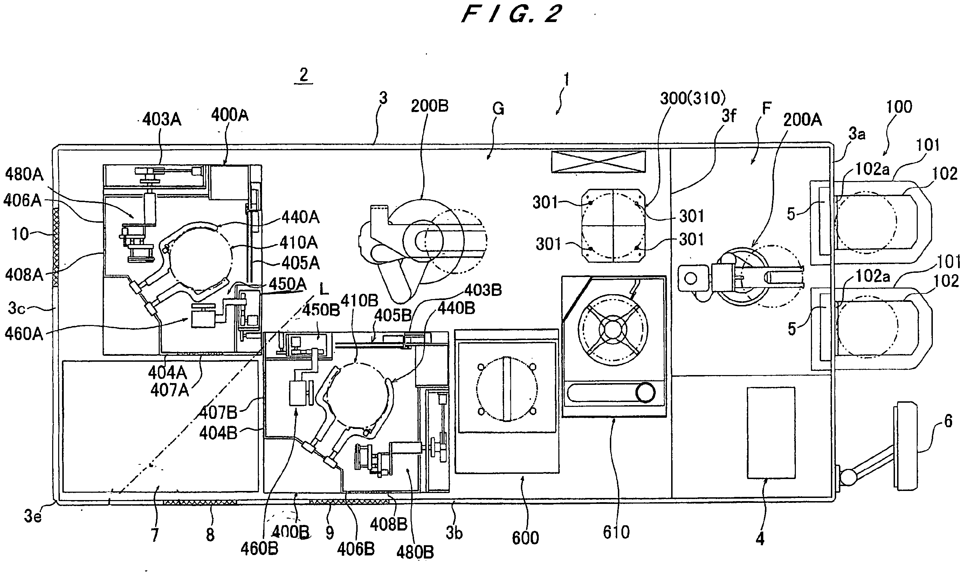

A substrate processing apparatus according to embodiments of the present invention will be described below with reference to FIGS. 2 through 36. Like or corresponding parts are denoted by like or corresponding reference numerals throughout drawings and will not be described below repetitively.

FIG. 2 is a schematic plan view showing an entire arrangement of a substrate processing apparatus 1 according to an embodiment of the present invention. As shown in FIG. 2, the substrate processing apparatus 1 includes a loading/unloading port 100 having wafer supply/recovery devices 101 disposed thereon, a wafer stage 300 on which a wafer is placed and/or a measurement unit 310 for measuring a shape and surface conditions of a peripheral portion of a wafer and the presence of defects on the peripheral portion of the wafer, a first transfer robot 200A for transferring a wafer mainly between the loading/unloading port 100, the wafer stage 300, the measurement unit 310, and a secondary cleaning and drying unit 610, a first polishing unit 400A for polishing a peripheral portion of a wafer, a second polishing unit 400B for polishing a peripheral portion of a wafer, a primary cleaning unit 600 for cleaning a polished wafer, a secondary cleaning and drying unit 610 for performing a secondary cleaning process on a wafer and drying the wafer, and a second transfer robot 200B for transferring a wafer mainly between the first polishing unit 400A, the second polishing unit 400B, the primary cleaning unit 600, and the secondary cleaning and drying unit 610. The substrate processing apparatus 1 also includes a polishing condition decision unit (not shown) for determining polishing conditions in the polishing units 400A and 400B based on the measurement results of the wafer by the measurement unit 310, such as the shape and the surface conditions of the peripheral portion of the wafer and the presence of defects on the peripheral portion of the wafer. In FIG. 2, the reference numeral 4 denotes a power supply and a controller, and the reference numeral 6 denotes a control panel. In the specification, the term "unit" is used to describe an assembly (module) of a process device disposed in the substrate processing apparatus 1. Arrangements and operations of the units in the substrate processing apparatus 1 will be described in greater detail.

The units of the substrate processing apparatus 1 are housed in a housing 3 disposed in a clean room 2. An inner space of the substrate processing apparatus 1 is partitioned from an inner space of the clean room 2 by walls of the housing 3. Further, the substrate processing apparatus 1 has a transfer region F in which the first transfer robot 200A is disposed and a process region G in which the other units are disposed. Clean air is introduced into the internal space of the substrate processing apparatus 1 through a fan unit (not shown) having an air supply fan, a chemical filter, a HEPA filter, and a ULPA filter provided at an upper portion of the housing 3. The fan unit is configured to draw air through an air duct (not shown) from an upper portion of the substrate processing apparatus 1 and supply clean air that has passed through the filters in a downward direction. Air inside the housing 3 is discharged to the exterior of the substrate processing apparatus 1 through a discharge section (not shown) provided at a lower portion of the housing 3. Thus, a downflow of clean air is formed in the housing 3. Accordingly, a downflow of clean air is formed onto a surface of a wafer transferred within the substrate processing apparatus 1 to prevent contamination of the wafer.

### 1. Loading/unloading Port

An arrangement of the loading/unloading port 100 will be described. In the substrate processing apparatus 1 shown in FIG. 2, the loading/unloading port 100 is provided outside of a sidewall 3 a adjacent to the transfer region F. Standard mechanical interface (SMIF) pods or front opening unified pods (FOUP) 101 are used as loading/unloading stages on which wafer cassettes 102 are placed. The SMIF pod or FOUP 101 has receptacle walls for housing a wafer cassette 102 and is a hermetically sealed container capable of maintaining an internal environment independently of an external environment. The loading/unloading port 100 is configured such that SMIF pods or FOUPs 101 can be attached to the wall 3 a of the substrate processing apparatus 1. The wall 3 a has a shutter 5 capable of being open and close. When a wafer cassette 102 housing wafers is placed on the SMIF pod or FOUP 101, the shutter 5 of the substrate processing apparatus 1 and a shutter 102a provided in a side surface of the SMIF pod or FOUP 101 are opened to communicate with each other. Thus, the substrate processing apparatus 1 and the wafer cassette 102 are integrated with each other so as to allow wafers in the wafer cassette 1.02 to be introduced into the substrate processing apparatus 1 without exposure to an external atmosphere.

When substrate processing is completed, the shutter 5 is closed. The SMIF pod or FOUP 101 is automatically or manually separately from the substrate processing apparatus 1 and transferred to another process. Accordingly, contaminated air should not be introduced into an inner space of the SMIF pod or FOUP 101. For this purpose, a chemical filter (not shown) is provided above the transfer region F, through which the wafers have passed before they are returned to the wafer cassette 102. A downflow of clean air is formed through the chemical filter. In order to maintain clean wafers in the wafer cassette 102, the SMIF pod or FOUP 101 of a hermetically sealed container may have a chemical filter or a fan to maintain the cleanliness of the container.

Since the two SMIF pods or FOUPs 101 are provided in parallel in the substrate processing apparatus 1, wafers can be transferred in parallel from and to these two SMIF pods or FOUPs 101. Thus, it is possible to improve a rate of operation in the substrate processing apparatus 1. Specifically, a wafer in the wafer cassette 102 mounted on one of the SMIF pods or FOUPs 101 is transferred into the substrate processing apparatus 1, and then a wafer in the wafer cassette 102 mounted on the other of the SMIF pods or FOUPs 101 is transferred into the substrate processing apparatus 1. At that time, the wafer cassette 102 mounted on the one of the SMIF pods or FOUPs 101, which becomes empty, can be replaced so that wafers are continuously introduced into the substrate processing apparatus 1.

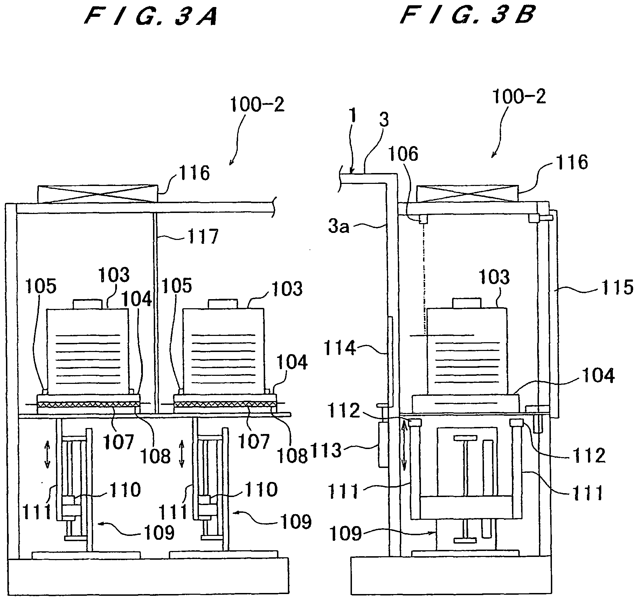

FIG. 3A is a front view showing another example of the loading/unloading port 100, and FIG. 3B is a side view of FIG. 3A. The loading/unloading port 100-2 has loading/unloading stages 104 in the form of a plate. A wafer cassette 103 is placed on the loading/unloading stage 104. Each of the loading/unloading stages 104 has a positioning mechanism including a block 105 corresponding to a shape of a lower surface of the wafer cassette 103. Accordingly, the wafer cassette 103 is always positioned at the same location each time the wafer cassette 103 is repeatedly placed on the loading/unloading stage 104. The loading/unloading stage 104 includes a button-type sensor (not shown) for detecting the presence of the wafer cassette 103 correctly placed on the loading/unloading stage 104. Further, transmission optical sensors 106 are provided as wafer projection detecting mechanisms above the loading/unloading stages 104. The transmission optical sensor 106 detects any wafer projecting from the wafer cassette 103 to confirm that the wafers are correctly housed in slots of the wafer cassette 103. If the transmission optical sensor 106 detects projection of any wafer, an interlock is operated to prevent access of the first transfer robot 200A and wafer search mechanisms 109 to the loading/unloading stage 104.

Dummy wafer stations 107 are disposed below the respective loading/unloading stages 104. The dummy wafer station 107 receives at least one wafer including a dummy wafer used for stabilizing conditions in the first and second polishing units 400A and 400B before product wafers are processed or a quality control (QC) wafer for confirming conditions of the substrate processing apparatus 1. The dummy wafer station 107 has a sensor 108 for detecting a wafer to confirm the presence of the wafer. The dummy wafer station 107 may have a sensor for detecting any wafer projecting from the dummy wafer station 107. Alternatively, the dummy wafer station 107 may employ the aforementioned wafer projection detecting mechanism of the transmission optical sensors 106. A wafer is placed onto the dummy wafer station 107 as follows. The wafer cassette 103 housing wafers is placed on the loading/unloading stage 104, and then wafers are searched to determine a wafer to be transferred to the dummy wafer station 107. Commands are sent from the control panel 6 (see FIG. 2) to transfer the wafer from the wafer cassette 103 to the dummy wafer station 107 by the first transfer robot 200A. Alternatively, when no wafer cassette 103 is placed on the loading/unloading stage 104, the loading/unloading stage 104 may be lifted to place a wafer manually on the dummy wafer station 107.

As shown in FIGS. 3A and 3B, wafer searching mechanisms 109 are disposed below the respective loading/unloading stages 104. Each of the wafer searching mechanisms 109 has a pair of support members 111, a driving source (pulse motor) 110 for moving the support members 111 in a vertical direction, and search sensors 112 attached to upper ends of the support members 111. When the wafer searching mechanism 109 is not in operation for wafer searching, the wafer searching mechanism 203 is lowered and held in a standby position, which is shown in FIGS. 3A and 3B, in order not to interfere with a transferring wafer cassette 103 or the like. As shown in FIG. 3B, the search sensors 112 are disposed in horizontally confronting relation to each other such that light traveling between the search sensors 112 passes horizontally through the wafer cassette 103.

A wafer searching operation is performed as follows. The wafer searching mechanism 109 moves up from a position below the dummy wafer station 107 to a position above the uppermost slot in the wafer cassette 103 and then moves down to the position below the dummy wafer station 107. During this movement, the pair of the search sensors 112 counts the number of times that the light is interrupted by a wafer, thereby counting the number of wafers in the wafer cassette 103. At that time, the wafer searching mechanism 109 determines the positions of the wafers based on the pulses of the pulse motor in the driving source 110, thereby determining which slots in the wafer cassette 103 the wafers are inserted into. The wafer searching mechanism 109 also has an oblique wafer detecting function, which detects an obliquely inserted wafer when the light between the search sensors 112 is interrupted for a period of time corresponding to the number of pulses that is greater than the number of pulses corresponding to a spacing between the slots in the wafer cassette 103. The spacing between the slots in the wafer cassette 103 is preset in advance.

As shown in FIG. 3B, a shutter 114 is disposed between an opening in the wafer cassette 103 and the substrate processing apparatus 1. The shutter 114 is vertically movable by a cylinder 113. Thus, the shutter 114 can separate the loading/unloading port 100-2 and the interior of the substrate processing apparatus 1 from each other. The shutter 114 is closed except when the first transfer robot 200A transfers a wafer to or from the wafer cassette 103. As shown in FIG. 2A, partition walls 117 are disposed between the adjacent loading/unloading stages 104 provided on the sidewall 3a of the substrate processing apparatus 1. Thus, with the partition walls 117, when an operator accesses any wafer cassette for replacement, the operator is prevented from erroneously touching an adjacent wafer cassette which is in operation. As shown in FIG. 3B, doors 115 are provided in front of the loading/unloading port 100-2 for separating from the exterior of the apparatus. The door 115 has a locking mechanism (not shown) and a sensor for detecting whether the door 115 is opened or closed. When the apparatus is in operation, the doors 115 are locked by the locking mechanisms to protect the wafer cassette 103 and forestall danger to the operator. If any one of the doors 115 is left opened for a certain period of time, then an alarm is issued.

The following two methods may be used in order to place a wafer cassette 103 on one of the loading/unloading stages 104.
(1) A wafer cassette 103 having wafers therein is placed directly on one of the loading/unloading stages 104. This process is employed when a space in the clean room 2 facing the loading/unloading port 100 is relatively clean, e.g., it has a cleanliness of class 100 or lower. In this case, a filter fan unit 116 should be mounted above the loading/unloading port 100 (100-2) to maintain a clean atmosphere around the loading/unloading stages 104 in the loading/unloading port 100.
(2) When the space in the clean room 2 facing the loading/unloading port 100 is relatively dirty, e.g., it has a cleanliness of class 1000 or higher, a wafer cassette 103 is placed in a box, which is controlled at a cleanliness of about class 100, delivered in the clean room 2, and placed on one of the loading/unloading stages 104.

The above transfer operation (2) of a wafer from the loading/unloading port 100 will be described below.

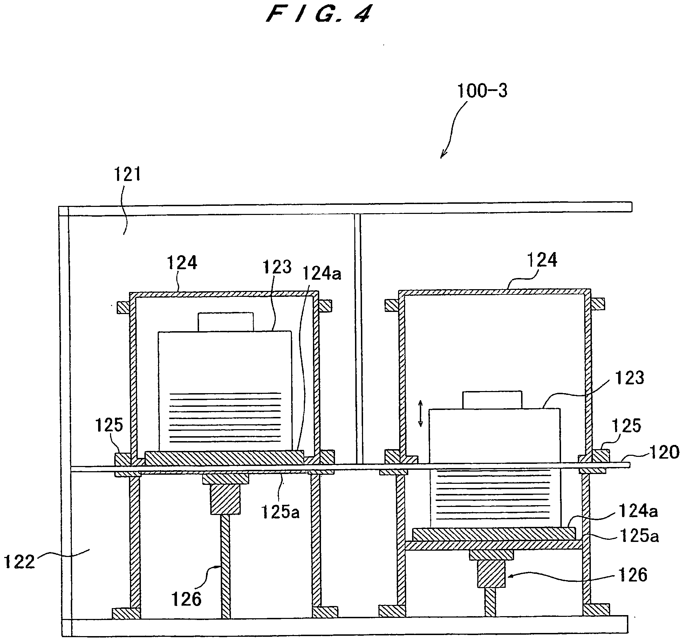

FIG. 4 is a schematic front view showing another example of the loading/unloading port 100. The loading/unloading port 100-3 has a partition wall 120 extending in a horizontal direction for dividing an internal space into an upper space 121 and a lower space 122. A wafer cassette 123 having wafers therein is housed in a hermetically sealed receiving box 124 and placed on a loading/unloading stage 125, which is provided in the upper space 121. The receiving box 124 includes a detachable base plate 124a. The base plate 124a is fixed to the bottom of the receiving box 124 in a hermetically sealed manner during transfer. When the receiving box 124 is placed on the loading/unloading stage 125, the base plate 124a is fixed to a placement plate 125a of the loading/unloading stage 125 by a locking mechanism (not shown). As soon as the placement plate 125a and the base plate 124a are fixed, a lower end of the receiving box 124 is firmly fixed to the loading/unloading stage 125. Simultaneously, fixing of the base plate 124a to the receiving box 124 is released. Thus, the base plate 124a becomes movable in a vertical direction together with the placement plate 125a.

The placement plate 125a is attached to a vertical movement mechanism 126. Thus, the placement plate 125a is vertically movable in a state such that the base plate 124a and the wafer cassette 123 are placed on the placement plate 125a. When it is confirmed that the placement plate 125a and the base plate 124a are locked, the placement plate 125a is lowered to introduce the wafer cassette 123 into the lower space 122. The upper space 121 is an atmosphere that is contaminated to a degree equal to a space outside of the substrate processing apparatus 1. The lower space 122 is maintained in a state as clean as the interior of the substrate processing apparatus 1. Accordingly, wafers in the wafer cassette 123 can be transferred into the substrate processing apparatus 1 without exposure to the dirty atmosphere of the upper space 121. In this case, a hand of the first transfer robot 200A is moved to a height of a wafer in the lower space 122 to introduce the wafer into the substrate processing apparatus 1.

### 2. First Transfer Robot

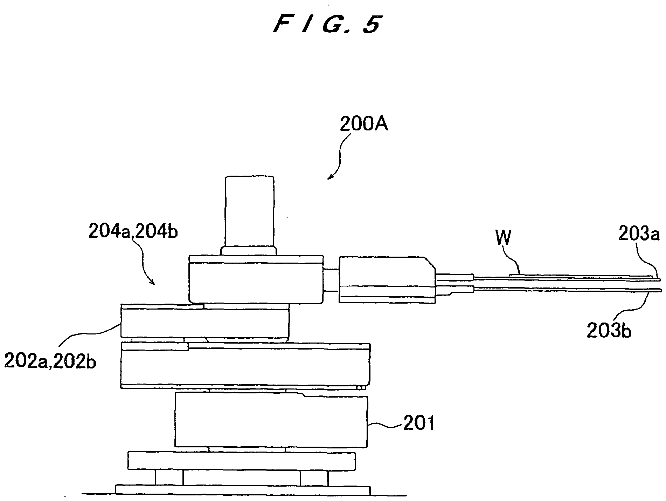

Next, the first transfer robot 200A will be described below. FIG. 5 is a side view showing the first transfer robot 200A. As shown in FIG. 5, the first transfer robot 200A includes a base 201 having a rotation mechanism for rotating the base 201 on the horizontal plane and a pair of handling mechanisms 204a and 204b provided on an upper surface of the base 201. The base 201 has a vertical movement mechanism for adjusting a height of the upper surface of the base 201. The handling mechanisms 204a and 204b include upper and lower hands 203a and 203b attached to tips of expandable arm mechanisms 202a and 202b for holding wafers. The upper and lower hands 203a and 203b are vertically spaced at a predetermined interval. Rotation of the base 201 and expanding operation (horizontal movement) of the arm mechanisms 202a and 202b move the upper and lower hands 203a and 203b to desired positions, respectively, to thereby transfer the wafer to predetermined locations.

Each of the upper hand 203a and the lower hand 203b has a vacuum line (not shown). Thus, both of the upper hand 203a and the lower hand 203b can be used as a vacuum suction hand. Alternatively, the lower hand 203b may be used as an attraction-type hand to attract a wafer under vacuum, and the upper hand 203 a may be used as a recess-type hand to hold a peripheral portion of a wafer. The attraction-type hand can transfer a wafer with accuracy irrespective of displacement of the wafer in the wafer cassette 102. The recess-type hand can transfer a wafer while maintaining a cleanliness of a rear face of the wafer because the recess-type hand does not collect dust unlike the attraction-type hand. It is desirable to use a recess-type hand for wafers that have been subjected to a cleaning process. In this case, the upper hand 203a should comprise a recess-type thin hand made of ceramics. The recess-type thin hand made of ceramics is used for a transfer process from receiving a wafer from the secondary cleaning and drying unit 610 to returning the wafer to the wafer cassette 102. The lower hand 203b may comprise a forked vacuum suction hand made of ceramics, which has a vacuum line. The lower hand 203b is used for a transfer process from receiving a wafer from the wafer cassette 102 to delivering the wafer to the wafer stage 300 or the measurement unit 310. Thus, since the upper hand 203a and the lower hand 203b are used for separate purposes, clean wafers that have been subjected to a cleaning process can be transferred without contamination due to attachment of a cleaning liquid or foreign matter.

### 3. Second Transfer Robot

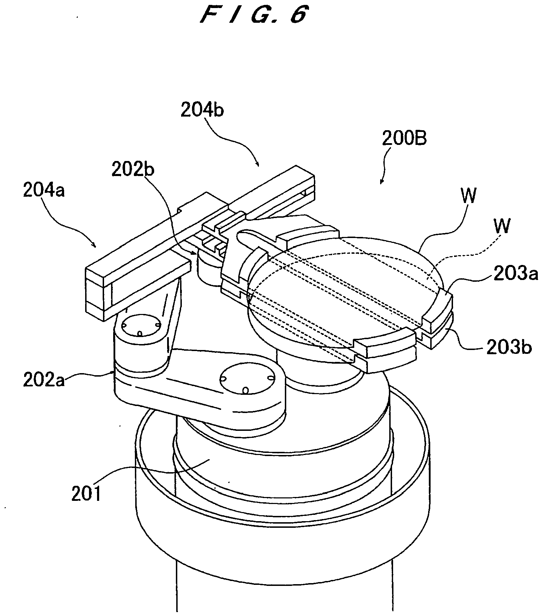

Next, the second transfer robot 200B will be described below. FIG. 6 is a perspective view showing the second transfer robot 200B. In FIG. 6, components corresponding to the components of the first transfer robot 200A shown in FIG. 5 are denoted by the same reference numerals, and details of such components will not be described.

The second transfer robot 200B has an upper hand 203a and a lower hand 203b, each of which comprises a recess-type hand to hold a peripheral portion of a wafer. The upper hand 203a is used to hold a wafer W that is not wet. Specifically, the upper hand 203a is used to transfer a wafer from the wafer stage 300 or the measurement unit 310 to the first polishing unit 400A, the second polishing unit 400B, and the primary cleaning unit 600 and to transfer a wafer from the secondary cleaning and drying unit 610 to the wafer stage 300 or the measurement unit 310. The lower hand 203b is used to hold a wet wafer W. Specifically, the lower hand 203b is used to transfer a wafer in transfer processes other than the transfer processes of the upper hand 203a. Thus, a wet wafer W is located below a wafer W that is not wet. Accordingly, the wafer W that is not wet is prevented from being contaminated by a dropping cleaning liquid or the like.

### 4. Wafer Stage and/or Measurement Unit

As shown in FIG. 2, the wafer stage 300 is located at a position to which the first transfer robot 400A and the second transfer robot 400B are accessible. An unprocessed wafer transferred from the loading/unloading port 100 and a processed wafer transferred from the secondary cleaning and drying unit 610 are placed on the wafer stage 300 and delivered to a subsequent transfer robot. The wafer stage 300 has a plurality of mount pins 301 for supporting a peripheral portion of a wafer. The wafer stage 300 may have a sensor (not shown) for detecting the presence of a wafer.

Instead of the wafer stage 300, the measurement unit 310 may be provided at the position of the wafer stage 300. The measurement unit 310 has a function to measure a shape of a peripheral portion of a wafer before and after processing. A measurement unit having a diameter measurement mechanism for measuring a diameter of a wafer will be described as an example of the measurement unit 310.

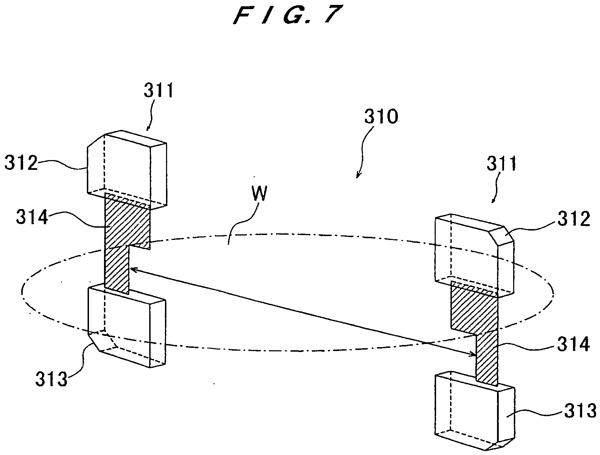

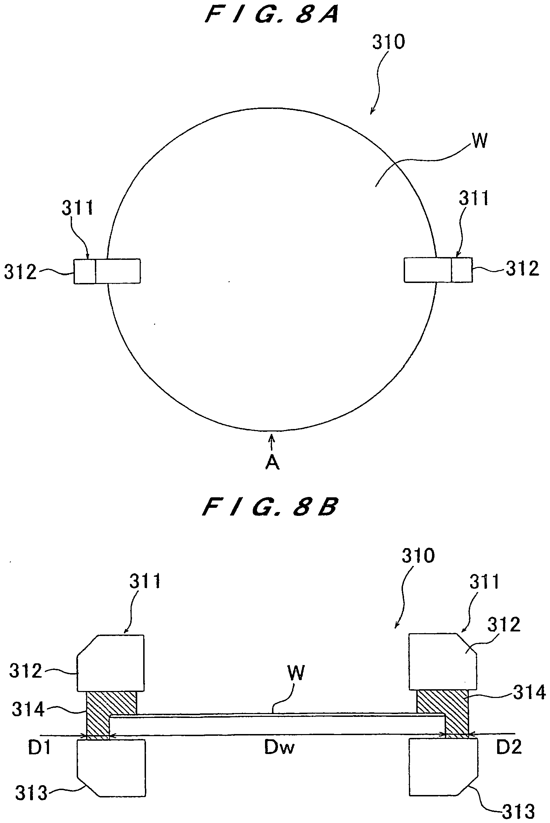

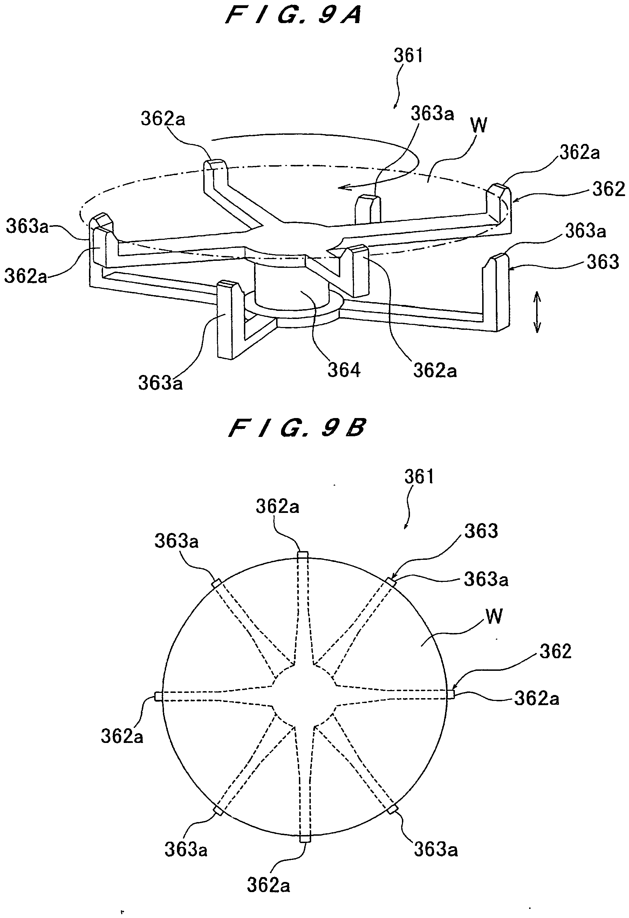

FIG. 7 is a perspective view schematically showing an example of the measurement unit 310. FIG. 8A is a schematic plan view of the measurement unit 310, and FIG. 8B is a view as seen in a direction A of FIG. 8A. FIG. 9A is a schematic perspective view of a substrate holding and rotating mechanism 361 provided in the measurement unit 310, and FIG. 9B is a schematic plan view of the substrate holding and rotating mechanism 361. In FIGS. 7, 8A, and 8B, the substrate holding and rotating mechanism 361 is not illustrated for brevity. The measurement unit 310 has a diameter measurement mechanism for measuring an outside diameter of a wafer W to detect the polishing amount of a side surface (of a bevel portion) of the wafer W. The measurement unit 310 includes a substrate holding and rotating mechanism 361 and sensor mechanisms (laser sensors) 311. The sensor mechanisms have two pairs of a light-emitting device 312 and a light-receiving device 313 vertically spaced near a peripheral portion of the wafer W held by the substrate holding and rotating mechanism 361. Each of the light-emitting devices 32 emits laser light.

The substrate holding and rotating mechanism 361 shown in FIGS. 9A and 9B serves to hold and rotate a wafer W at the time of measurement in the measurement unit 310. As shown in FIGS. 9A and 9B, the substrate holding and rotating mechanism 361 has a two-stage structure. The two-stage structure includes an upper chuck (upper spin chuck) 362 having a plurality of stages 362a for clamping an outer circumferential portion of the wafer W and a lower chuck (lower spin chuck) 363 having a plurality of stages 363a for clamping an outer circumferential portion of the wafer W. The upper chuck 362 and the lower chuck 363 are arranged coaxially and rotated about a rotational shaft 364. Each of the upper and lower chucks 362 and 363 has four stages 362a and 363a arranged at predetermined intervals. As shown in FIG. 9B, the stages 362a and 363a of the upper and lower chucks 362 and 363 are shifted at predetermined angles so that the stages 362a and 363a are not aligned with each other in the vertical direction. Further, the lower chuck 363 is vertically movable with respect to the upper chuck 362. The substrate holding and rotating mechanism 361 also has a rotation drive mechanism (not shown) for rotating the upper chuck 362 and the lower chuck 363 and an index mechanism (not shown) for indexing rotation and angles of the upper chuck 362 and the lower chuck 363 at constant speeds.

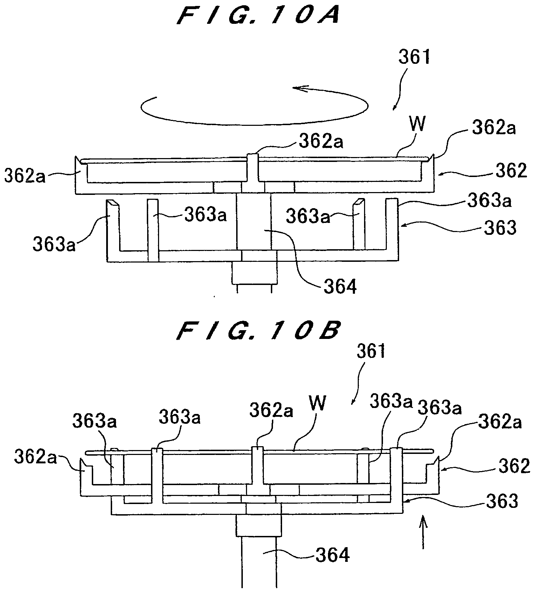

Operation of the substrate holding and rotating mechanism 361 will be described below with reference to FIGS. 10A and 10B. Usually, as shown in FIG. 10A, a wafer W is measured while the upper chuck 362 holds the wafer W. Before the stages 362a are positioned into a peripheral portion of the wafer W to be measured by rotation of the upper chuck 362, the lower chuck 363 is lifted as shown in FIG. 10B to hold the wafer W. Accordingly, the wafer W is disengaged with the stages 362a of the upper chuck 362. At that state, when the upper chuck 362 and the lower chuck 363 are rotated through predetermined angles, the stages 362a of the upper chuck 362 are prevented from being positioned into the measurement portion of the wafer W. After the stages 362a of the upper chuck 362 pass through the measurement portion of the wafer W, the lower chuck 363 is lowered. Then, the wafer W is held by the upper chuck 362. Such operation prevents the stages 362a of the upper chuck 362 from being positioned into the measurement portion of the wafer W. Accordingly, it is possible to measure the overall peripheral portion of the wafer W.

The measurement unit 310 shown in FIG. 7 has two sensor mechanisms 311 and 311. The two sensor mechanisms 311 and 311 are located across a center line of the wafer W held by the substrate holding and rotating mechanism 361. The sensor mechanisms 311 and 311 are connected to a data processing device (not shown) for digitalizing quantity of laser light received by the light-receiving devices 313. The light-receiving devices 313 may be disposed above the wafer W, and the light-emitting devices 312 may be disposed below the wafer W.

As shown in FIG. 8B, each of the sensor mechanisms 311 emits laser light 314 downward from the light-emitting device 312 to the peripheral portion of the wafer W. The emitted laser light 314 is in the form of a line or a surface and has a predetermined width. The emitted laser light 314 intersects the peripheral portion of the wafer W in the radial direction of the wafer W. Accordingly, a portion of the laser light 314 is blocked by the peripheral portion of the wafer W. Thus, only laser light 314 that has not been blocked by the wafer W and has passed outside of the wafer W is received by the light-receiving device 313. The quantity of received light is converted into numbers by the data processing device to calculate a width of the laser light 314 that has passed outside of the outer circumferential portion of the wafer W, i.e., each dimension D1, D2 shown in FIG. 8B. In order to calculate a diameter of the wafer, a reference wafer (not shown) having a known diameter is prepared and measured by the measurement unit 310 to obtain dimensions D1 and D2. Then, a diameter Dw of a wafer W to be measured can be calculated from differences between the dimensions D1, D2 of the reference wafer and the dimensions D1, D2 of the wafer to be measured and the diameter of the reference wafer.

Further, rotational angles of the upper chuck 362 and the lower chuck 363 in the substrate holding and rotating mechanism 361 are indexed to measure the diameter at a plurality of points on the peripheral portion of the wafer W. In this manner, it is possible to obtain information that cannot be obtained from one point measurement, such as variations of the polishing amount over the entire peripheral portion of the wafer W. Furthermore, the diameter of the wafer can continuously be measured while the wafer is rotated by the substrate holding and rotating mechanism 361. According to this method, the diameter of the wafer can be obtained as continuous data. Thus, it is possible to calculate the circularity of the wafer.

The measurement unit may have a cross-sectional shape measurement mechanism for measuring a cross-sectional shape of a peripheral portion of a wafer, a surface condition measurement mechanism for measuring surface conditions of a peripheral portion of a wafer, or a defect detection mechanism for detecting defective portions on a peripheral portion of a wafer. Further, the measurement unit may have a plurality of these mechanisms.

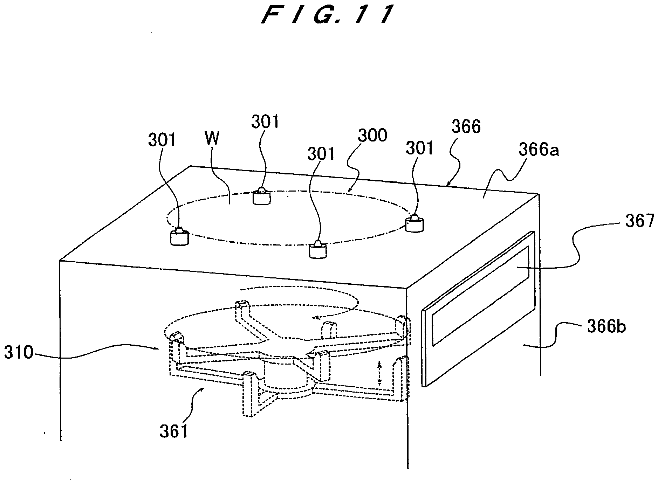

FIG. 11 is a perspective view showing an example in which the wafer stage 300 and the measurement unit 310 are both installed in the same space. In FIG. 11, only the substrate holding and rotating mechanism 361 is shown in the measurement unit 3 10, and other components are not shown for the purpose of illustration. Each of the wafer stage 300 and the measurement unit 310 may be provided singly. Alternatively, the wafer stage 300 may be provided above the measurement unit 310. In this case, as shown in FIG. 11, the measurement unit 310 is housed in a casing 366, and the wafer stage 300 is provided on an upper surface 366a of the casing 366. The wafer stage 300 has a plurality of mount pins 301 on which an outer circumferential portion of a wafer W is placed. Thus, the wafer stage 300 can be used as a temporary stage to temporarily receive a wafer W transferred by a hand of the first transfer robot 200A and transfer the wafer W to a hand of the second transfer robot 200B. Alternatively, the wafer stage 300 can be used as a standby stage to hold a subsequent wafer W when a previous wafer W occupies the measurement unit 310. The casing 366 has a sidewall 366b with a shutter 367 capable of opening and closing. When the shutter 367 is opened, a wafer held by the first or second transfer robot 200A or 200B can be introduced into the casing 366 and placed on the substrate holding and rotating mechanism 361 of the measurement unit 310 for measurement.

Thus, since the wafer stage 300 is provided above the measurement unit 310, both of the measurement unit 310 and the wafer stage 300 can be disposed in a common space. Accordingly, it is possible to reduce a space required for the substrate processing apparatus 1. Further, a wafer can be transferred efficiently in an optimized route as will be described in processing patterns of the substrate processing apparatus 1. Thus, it is possible to improve a throughput of the substrate processing apparatus 1.

### 5. First Embodiment of Polishing Unit

Next, structures of the first polishing unit 400A and the second polishing unit 400B will be described below. The first and second polishing units 400A and 400B have common structures. As shown in FIG. 2, respective components in casings of the first polishing unit 400A and the second polishing unit 400B are arranged symmetrically with respect to a center line L indicated by a dashed line. Specifically, the center line L is an axis of axial symmetry. The structures common to the first and second polishing units 400A and 400B will be described.

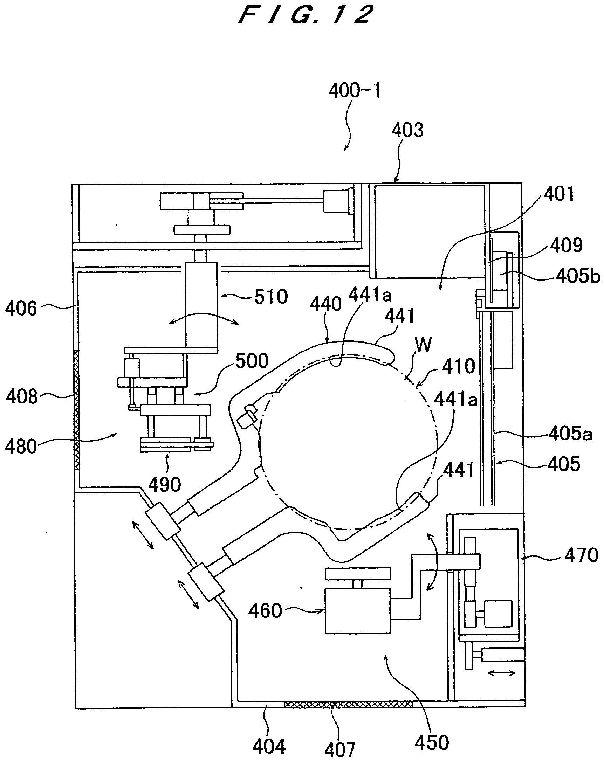

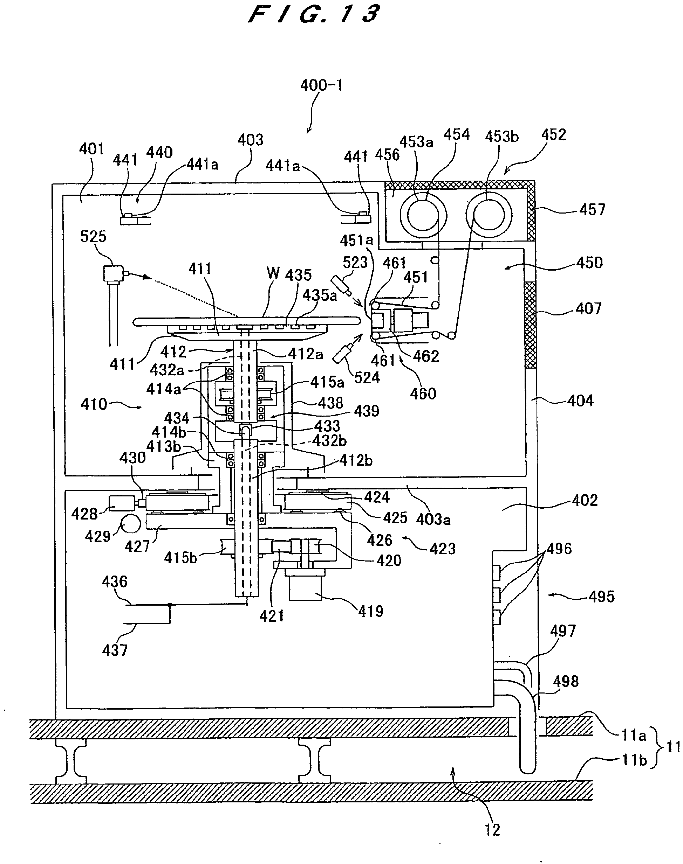

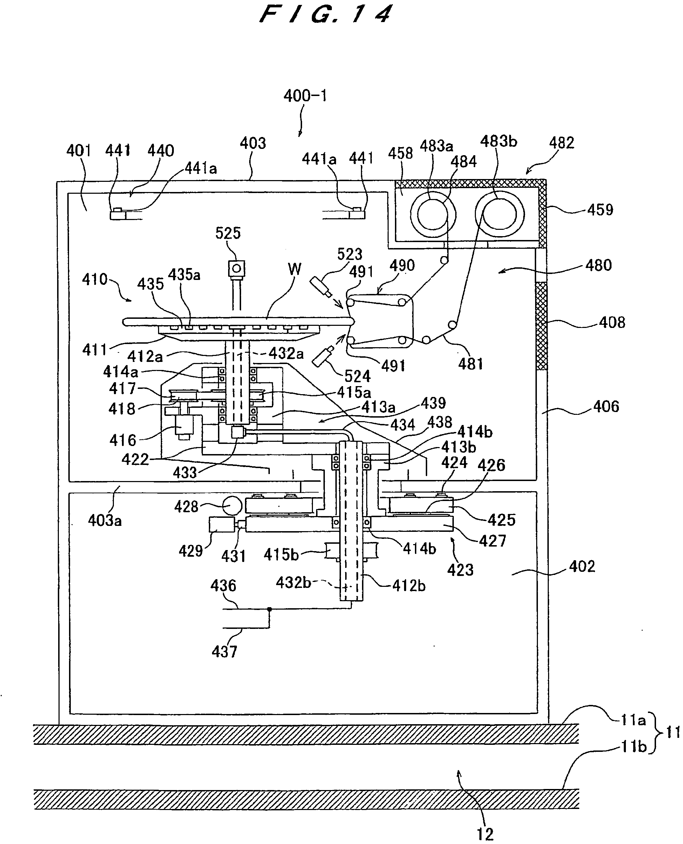

FIG. 12 is a schematic plan view showing a polishing unit 400-1 according to a first embodiment of the present invention. FIG. 13 is a cross-sectional side view of FIG. 12. FIG. 14 is a cross-sectional side view taken along a direction perpendicular to the cross-section of FIG. 13. As shown in FIGS. 12, 13, and 14, the polishing unit 400-1 has a casing 403, which defines a polishing chamber 401 at a central portion thereof and a plurality of machine chambers located above and below the polishing chamber 401, a substrate holding and rotating mechanism (substrate holding mechanism) 410 for holding and rotating a wafer W horizontally in the polishing chamber 401, a bevel polishing device 450 for polishing a bevel portion of the wafer W, and a notch polishing device 480 for polishing a notch of the wafer W.

As shown in FIG. 12, the casing 403 of the polishing unit 400-1 has sidewalls surrounding four sides of the polishing unit 400-1. The bevel polishing device 450 and the notch polishing device 480 are disposed inside of the two adjacent sidewalls 404 and 406, respectively. The bevel polishing device 450 and the notch polishing device 480 are arranged so as to surround the wafer W held by the substrate holding and rotating mechanism 410 in the polishing chamber 401. The bevel polishing device 450 has a bevel polishing head 460, and the notch polishing device 480 has a notch polishing head 490. The bevel polishing head 460 and the notch polishing head 490 are angularly spaced around the center of the wafer W at about 90 degrees.

In the polishing unit 400-1, the sidewall 404 near the bevel polishing head 460 has a maintenance hatch (door) 407, and the sidewall 406 near the notch polishing head 49 has a maintenance hatch (door) 408. The maintenance hatches 407 and 408 face the bevel polishing head 460 and the notch polishing head 490, respectively. When the maintenance hatch 407 is opened, an operator is accessible to the bevel polishing head 460 from the exterior of the polishing unit 400-1. When the maintenance hatch 408 is opened, an operator is accessible to the notch polishing head 490. The sidewall 409 of the polishing unit 400-1 has an opening 405 for allowing a wafer W to be introduced into and discharged from the polishing chamber 401. The polishing unit 400-1 has a shutter 405a for covering the opening 405 and an air cylinder 405b for actuating the shutter 405a. In the polishing unit 400-1 shown in FIG. 12, the opening 405 is formed in the sidewall 409 which is opposed to the sidewall 406 near the notch polishing head 490.

As shown in FIGS. 13 and 14, the substrate holding and rotating mechanism 410 has a substrate holding table 411 for horizontally holding a wafer W on an upper surface thereof and a rotational shaft 412 coupled to a lower surface substrate holding table 411. The rotational shaft 412 is divided into an upper rotational shaft 412a and a lower rotational shaft 412b at a central portion thereof. The upper rotational shaft 412a and the lower rotational shaft 412b are parallel to each other and are horizontally spaced at a predetermined distance. The upper rotational shaft 412a is rotatably attached to an inner surface of a support member 413a via bearings 414a. A pulley 415a is attached to the upper rotational shaft 412a. A motor 416 is fixed onto the support member 413a. A pulley 417 is attached to a rotational shaft of the motor 416. The pulley 415a is connected to the pulley 417 via a timing belt 418. Thus, when the motor 416 is driven, the upper rotational shaft 412a is rotated so as to rotate the substrate holding table 411.

The lower rotational shaft 412b is rotatably supported by bearings 414b fixed onto an inner circumferential surface of a support member 413b. A pulley 415b is fixed to the lower rotational shaft 412b. A motor 419 is fixed onto the support member 413b. A pulley 420 is attached to a rotational shaft of the motor 419. The pulley 415b is connected to the pulley 420 via a timing belt 421. Thus, when the motor 419 is driven, the lower rotational shaft 412b is rotated via the pulley 420 and the timing belt 421. The upper rotational shaft 412a can be swung about the lower rotational shaft 412b by rotating the motor 419 through a predetermined angle. In this manner, the motor 419 and the lower rotational shaft 412b form a substrate holding table swing mechanism 439 for swinging the substrate holding table 411, which is connected to the upper rotational shaft 412a, on the horizontal plane. In order to prevent a treatment liquid from being attached to mechanical components of the substrate holding and rotating mechanism 410, a cover 438 is provided so as to cover the rotational shaft 412, the support member 413, and the like.

The support member 413a and the support member 413b are connected to each other by a plate member 422. The support member 413b is attached via a horizontal movement mechanism (substrate holding table horizontal movement mechanism) 423 to a base plate 403a, which is provided at an interface between the polishing chamber 401 and the machine chamber 402. The horizontal movement mechanism 423 includes an upper plate 425 attached to the base plate 403a, linear guides 424 for sliding the upper plate 425 in a first direction with respect to the base plate 403a, a lower plate 427 attached to the upper plate 425, and linear guides 426 for sliding the lower plate 427 in a second direction, which is perpendicular to the first direction, with respect to the upper plate 425. The horizontal movement mechanism 423 allows the support member 413 (413a and 413b) to linearly move in two directions (X-Y directions), which are perpendicular to each other on the horizontal plane, with respect to the base plate 403a. Thus, the horizontal movement mechanism 423 serves as an X-Y stage. Servomotors 428 and 429 and ball screws 430 and 431 are fixed to the upper plate 425 and the lower plate 427, respectively. When the servomotors 428 and 429 are driven, the upper plate 425 and the lower plate 427 are linearly moved along the linear guides 424 and 426, respectively.

A polishing pad 435 is attached to an upper surface of the substrate holding table 411. The polishing pad 435 has an upper surface with grooves 435a formed therein. The polishing pad 435 is made of elastic material such as urethane. Thus, the polishing pad 435 is adopted to hold a wafer W without damaging a rear face of the wafer W and to hermetically seal a contact portion with the wafer W. The grooves 435a communicate via the substrate holding table 411 with a communication passage 432a formed within the upper rotational shaft 412a. The communication passage 432a in the upper rotational shaft 412a is connected via a rotary joint 433 to a pipe 434, which is connected to a communication passage 432b in the lower rotational shaft 412b. The communication passage 432b in the lower rotational shaft 412b is connected to a vacuum line 436 and a compressed air supply line 437. Accordingly, vacuum is supplied via the vacuum line 436 to form a vacuum in the grooves 435a of the polishing pad 435. Thus, a wafer W placed on the substrate holding table 411 is attracted onto the upper surface of the polishing pad 435 under vacuum.

Further, a substrate transfer mechanism 440 is disposed above the substrate holding and rotating mechanism 410. The substrate transfer mechanism 440 has a pair of arms 441 and 441, which have holding portions 441a and 441a corresponding to a bevel portion of the wafer W. The arms 441 and 441 are capable of opening and closing in directions indicated by arrows shown in FIG. 12 and can have a close position and a release position. The arms 441 and 441 can sandwich the wafer W between the holding portions 441a and 441a at the close position and can release the wafer W at the release position. When the wafer W is clamped by the arms 441 and 441, the wafer W is centered.

The polishing unit 400-1 includes supply pipes (not shown) for supplying liquid or gas (e.g., pure water or gas) to the respective components, such as the substrate holding and rotating mechanism 410, the bevel polishing device 450, and the notch polishing device 480, and various pipes (not shown) such as a drainage pipe for a waste liquid discharged from the respective components. As shown in FIG. 13, the pipes connected to the respective components are aggregated at a spacing section 495 provided at a lower portion of the sidewall 404 near the bevel polishing device 450. The polishing unit 400-1 is disposed on a base portion 11 provided at a lower portion of the substrate processing apparatus 1. The base portion 11 includes an upper base 11 a in the form of a plate and a lower base 11b in the form of a plate. A space 12 is formed between the upper base 11 a and the lower base 11b. The space 12 houses supply pipes (not shown) for supplying liquid or gas (e.g., air, N₂ gas, pure water, or chemical liquid) to the respective units, such as the polishing unit 400, the primary cleaning unit 600, and the secondary cleaning and drying unit 610 in the substrate processing apparatus 1, and various pipes (not shown) such as a drainage pipe for a waste liquid discharged from the respective units. As shown in FIG. 13, the pipes housed in the space 12 are branched into a supply pipe 497, a drainage pipe 498, and the like. The supply pipe 497 and the drainage pipe 498 are connected to the spacing section 495 in the polishing unit 400-1 and then connected via the spacing section 495 to pipes in the polishing unit 400-1.

The polishing unit 400-1 also includes electric cables (not shown) for supplying power to motors or the like and wiring (not shown) such as control signal lines for supplying control signals to various sensors. These cables are aggregated at the spacing section 495 and connected to power supply/signal connectors 496 provided at the spacing section 495. The space 12 at the base portion 11 houses electric cables and control signal lines (not shown) connected to power sources and the controller 4 in the substrate processing apparatus 1. Branched lines from these lines are connected to the power supply/signal connectors 496. Thus, connection of pipes to the polishing unit 400-1 is conducted via the spacing section 495 provided on the sidewall 404 in the substrate processing apparatus 1.

As shown in FIG. 13, the bevel polishing device 450 includes a polishing tape 451, a bevel, polishing head 460 for pressing the polishing tape 451 against a bevel portion of a wafer W, and a polishing tape supply/recovery mechanism 452 for supplying the polishing tape 451 to the bevel polishing head 460 and recovering the polishing tape 451 from the bevel polishing head 460. The bevel polishing head 460 has a pair of feed rollers 461 and 461 for holding the polishing tape 451 therebetween at a position facing the substrate holding table 411. Thus, the polishing tape 451 extends between a pair of the feed rollers 461 so that the bevel portion of the wafer W is brought into contact with a polishing surface 451a of the polishing tape 451. The bevel polishing head 460 has a base 462 disposed on a rear side of the polishing tape 451 extending between the feed rollers 461 and 461. The base 462 may have an elastic member (not shown) attached to a surface of the base 462 which contacts the polishing tape 451. The polishing surface 451a of the polishing tape 451 is pressed against the bevel portion or the peripheral portion (bevel portion and edge portion) of the wafer W by a force of the base 462 to press the polishing tape 451 from the rear side and a tension of the polishing tape 451 itself.

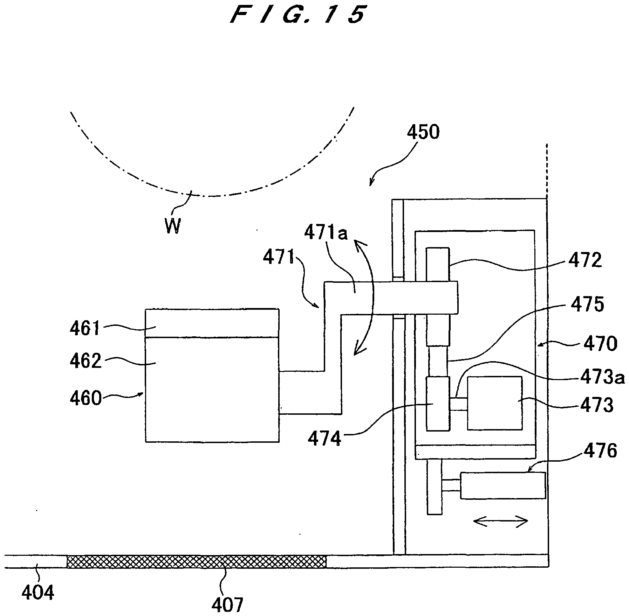

FIG. 15 is an enlarged plan view schematically showing the bevel polishing device 450. As shown in FIG. 15, the bevel polishing head 460 of the bevel polishing device 450 is coupled via a crank member 471 to a swing mechanism 470. The crank member 471 is attached to a side surface of the bevel polishing head 460. The swing mechanism 470 includes a pulley 472 fixed to a crank axis 471a of the crank member 471, a motor 473, a pulley 474 fixed to a rotational shaft 473a of the motor 473, and a timing belt 475 interconnecting the pulley 472 and the pulley 474. The motor 473 is operable to rotate the pulley 474 in opposite directions at a predetermined frequency. By rotation of the motor 473, the bevel polishing head 460 is swung via the crank member 471 in a vertical direction. The crank axis 471a extends in a tangential direction of the wafer W placed on the substrate holding table 411. The bevel polishing head 460 can be swung (pivoted or tilted) around the peripheral portion of the wafer W in a vertical direction with respect to the wafer surface. Thus, the polishing tape 451 can be brought into contact with the bevel portion of the wafer W at desired angles.

The swing mechanism 470 is coupled to a reciprocation movement mechanism 476 for reciprocating the bevel polishing head 460 along the tangential direction of the wafer W. An air cylinder may suitably be used as the reciprocation movement mechanism 476. The reciprocation movement mechanism 476 reciprocates the swing mechanism 470 and the crank member 471 along the direction in which the crank axis 471a extends. Thus, the bevel polishing head 460 connected to the crank member 471 is reciprocated (oscillated) along the tangential direction of the wafer. Since the bevel polishing device 450 has the swing mechanism 470 and the reciprocation movement mechanism 476, the bevel polishing head 460 can be swung about the peripheral portion of the wafer W and reciprocated along the tangential direction of the wafer W.

Referring back to FIG. 13, a machine chamber 456 is disposed above the polishing chamber 401 so as to face the sidewall 404. The polishing tape supply/recovery mechanism 452 is provided in the machine chamber 456. The polishing tape supply/recovery mechanism 452 includes a feed reel 453a for feeding the polishing tape 451 to the bevel polishing head 460 and a taken reel 453b for recovering the polishing tape 451 from the bevel polishing head 460. The polishing tape 451 is formed by a beltlike member having a predetermined width in a range of 1 inch to 3 inches and a length of about several tens of meters. The polishing tape 451 is wound around a cylindrical core member 454. The core member 454 is attached to the feed reel 453a. The polishing tape 451 extends between the pair of the feed rollers 461 and 461 in the bevel polishing head 460 in a state such that the polishing surface 451a faces outward. Then, the polishing tape 451 is attached to the takeup reel 453b. The takeup reel 453b is coupled to a rotation drive mechanism (not shown) such as a motor. The polishing tape 451 can be wound up and recovered with a predetermined tension applied thereto. When the bevel portion is to be polished, the polishing tape 451 is sequentially fed from the feed reel 453a to continuously provide a new polishing surface 451a to the bevel polishing head 460.

A maintenance hatch 457 is provided over the machine chamber 456 so as to extend upward from the sidewall 404. When the maintenance hatch 457 is opened, an operator is accessible to the polishing tape supply/recovery mechanism 452 from the exterior of the polishing unit 400-1. Thus, the operator can replace the polishing tape 451 with the feed reel 453a and the takeup reel 453b or conduct maintenance operation of the polishing tape supply/recovery mechanism 452.

Resin material in which abrasive particles are dispersed is applied to a surface of a tape base and solidified to form the polishing surface 451a of the polishing tape 451. Examples of the abrasive particles include diamond and SiC. Types and grain size of abrasive particles are selected according to the type of wafer to be polished or a required degree of polishing. For example, diamond having a grain size of #4000 to #11000 or SiC having a grain size of #4000 to #10000 can be used as abrasive particles. Further, a beltlike polishing cloth having no particles attached to its surface may be used instead of the polishing tape 451.

When a side surface of the bevel portion is polished with a polishing tape 451 having a small grain size, the wafer can be formed so as to have a desired diameter. In a case where a rough polishing process and a finish polishing process are performed in different polishing units 400-1, a polishing material having a low count (i.e., a rough polishing material of abrasive particles having a large particle diameter) is applied to a polishing tape 451, and the polishing tape 451 is mounted to the bevel polishing device 450 in a polishing unit 400 for rough polishing. At that time, a polishing material having a high count (i.e., a fine polishing material of abrasive particles having a small particle diameter) is applied to a polishing tape 451, and the polishing tape 451 is mounted to the bevel polishing device 450 in another polishing unit 400 for finish polishing. Thus, a plurality of polishing unit 400 are separately used for their purposes.

Examples of a polishing material having a low count include a polishing material of abrasive particles having an average particle diameter of 5 µm and a grain size of about #3000. Examples of a polishing material having a high count include a polishing material of abrasive particles having an average particle diameter of 0.2 µm and a grain size of about #20000. Generally, a polishing material of abrasive particles having a grain size larger than about #6000 is used for shaping, and a polishing material of abrasive particles having a grain size smaller than about #6000 is used for adjustment of the surface conditions.

More specifically, the tape base of the polishing tape 451 is formed by a beltlike polyethylene terephthalate (PET) resin having a thickness of about several tens of micrometers. A polishing layer to polish a wafer is formed on one surface of the tape base. Resin material in which abrasive particles such as diamond are dispersed is applied to the tape base, dried, and solidified to form the polishing layer. The polishing layer is a uniform layer having a thickness of about several micrometers and has a polishing surface 451 a thereon. Fine irregularities are formed in the polishing surface 451a by the dispersed abrasive particles.

The resin material in which abrasive particles are dispersed includes composite resin material into which various resin components are mixed. Properties of resin materials vary depending on manufacturers of polishing tapes. The hardened resin material should be water-insoluble. The hardened resin material should have a strength such that abrasive particles are not removed by frictional forces between the polishing surface and the wafer, which are produced during polishing. Further, the hardened resin material should not be softened due to frictional heat produced during polishing to a degree such that abrasive particles are separated. Furthermore, the hardened resin material is required to be chemically inactive. Particularly, the hardened resin material should be chemically inactive even if it gets wet with water (polishing water) supplied during polishing. Specifically, it is desirable that the resin material of the polishing tape has no chemical polishing effect. When a wafer W is polished with a polishing tape in which abrasive particles are fixed by resin material that meets the above requirements, it is possible to prevent abrasive particles from being readily separated during polishing. Chemical inactiveness of resin material means that the resin material does not chemically react with a wafer to be polished, abrasive particles, or water at polishing temperatures with mechanical sliding contact.

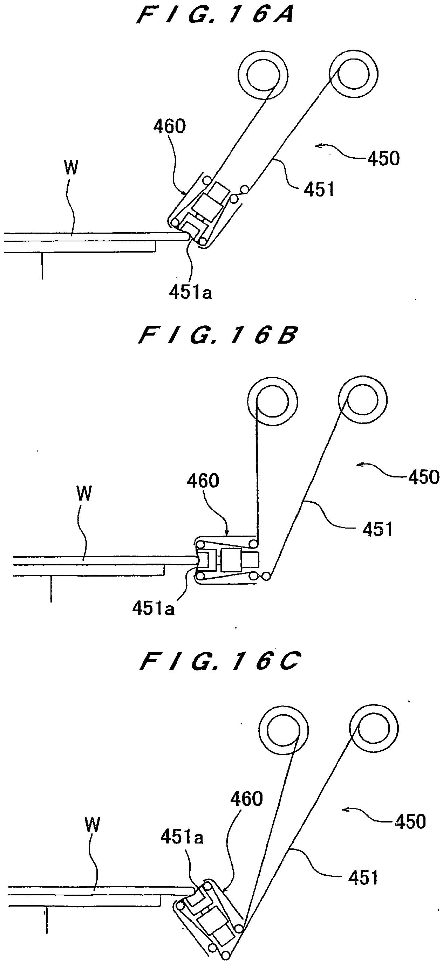

FIGS. 16A through 16C are schematic views explanatory of operation of the bevel polishing head 460. By the swing mechanism 470, the polishing surface 451a of the polishing tape 451 can be brought into contact with the polished area on the bevel portion of the wafer W from positions inclined at predetermined angles in the vertical direction with respect to the wafer surface. Accordingly, as shown in FIG. 16A, an upper inclined surface of the bevel portion can be polished in a state such that the bevel polishing head 460 is inclined downward at a predetermined angle with respect to the wafer surface. As shown in FIG. 16B, a side surface of the bevel portion can be polished by directing the bevel polishing head 460 in a horizontal direction. As shown in FIG. 16C, a lower inclined surface of the bevel portion can be polished in a state such that the bevel polishing head 460 is inclined upward at a predetermined angle with respect to the wafer surface.. Further, by making fine adjustments to the inclination angle of the bevel polishing head 460, the upper and lower inclined surfaces of the bevel portion, the side surface of the bevel portion, boundaries thereof, and an edge portion can be polished so as to have desired angles and shapes.

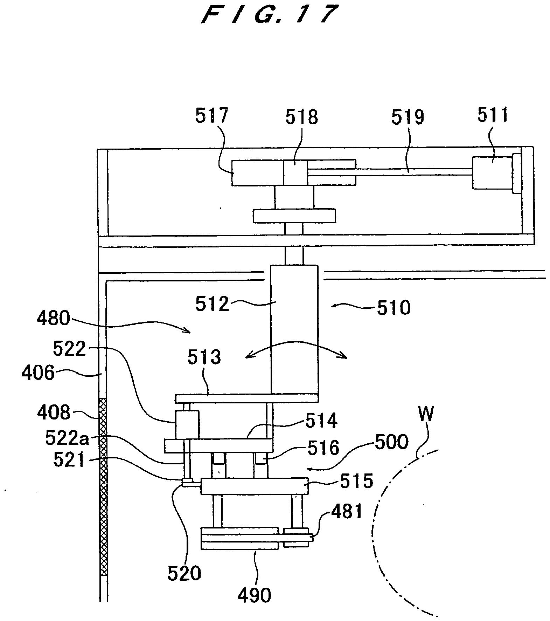

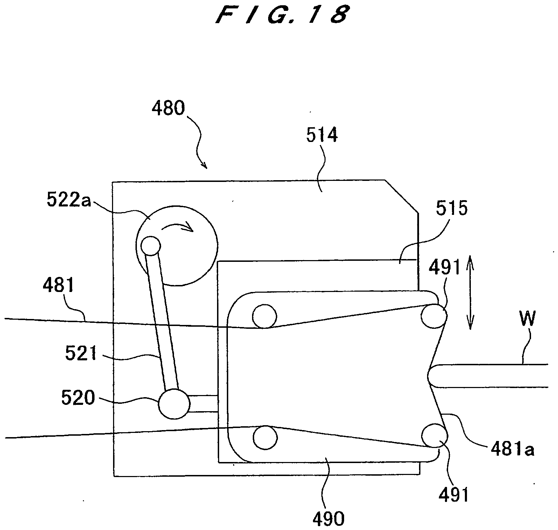

FIG. 17 is an enlarged plan view schematically showing the notch polishing device 480, and FIG.18 is a schematic side view showing an arrangement of the notch polishing head 490. As shown in FIGS. 17 and 18, the notch polishing device 480 includes the notch polishing head 490 for pressing a polishing tape 481 against a notch of a wafer W and a polishing tape supply/recovery mechanism 482. The notch polishing head 490 has a vertical movement mechanism 500 for moving the notch polishing head 490 in a vertical direction and a swing mechanism 510 for swinging the notch polishing head 490.

The swing mechanism 510 includes a motor 511, a rotational shaft 512 to which rotation of the motor 511 is transmitted, and a first support plate 514 fixed to an end of the rotational shaft 512. The first support plate 514 can be swung (rotated) about the rotational shaft 512. Specifically, the first support plate 514 is fixed to the end of the rotational shaft 512 via an attachment plate 513 and connected to a second support plate 515 and the notch polishing head 490. A gear 517 is provided on another end of the rotational shaft 512. The gear 517 engages with a worm 518, which has an axis 519 extending in a direction perpendicular to the rotational shaft 512. The axis 519 has an end coupled to a rotational shaft of the motor 511. Accordingly, when the motor 511 is driven, rotation of the motor 511 is converted into rotation of the rotational shaft 512 via the axis 519, the worm 518, and the gear 517. By rotating the motor 511 in opposite directions through a predetermined angle, the rotational shaft 512 is rotated in opposite directions to thereby swing the first support plate 514 about the rotational shaft 512. The notch polishing head 490 has a polishing area positioned on an extension of an axis of the rotational shaft 512. Thus, the notch polishing head 490 can be swung about the polishing area in a vertical direction.

The vertical movement mechanism 500 includes the second support plate 515 and linear guides 516 for moving the second support plate 515 in the vertical direction with respect to the first support plate 514. The notch polishing head 490 is fixed to the second support plate 515. As shown in FIG. 18, a hinge 520 is provided on a side portion of the second support plate 515, and an end of connecting rod 521 is coupled to the hinge 520. A motor 522 is fixed onto the first support plate 514. The motor 522 has a rotational shaft 522a extending through the first support plate 514. Another end of the connecting rod 521 is rotatably attached to an end of the rotational shaft 522a at a position eccentric from the center of the rotational shaft 522a. The hinge 520, the connecting rod 521, and the rotational shaft 522a form a crank mechanism. When the motor 522 is driven, the crank mechanism reciprocates the second support plate 515 in the vertical direction with respect to the first support plate 514. Thus, the notch polishing head 490, which is fixed to the second support plate 515, can be reciprocated around the polishing area in the vertical direction.

Referring back to FIG. 14, the notch polishing head 490 has a pair of feed rollers 491 and 491 for holding the polishing tape 481 therebetween at a position facing the wafer W held by the substrate holding and rotating mechanism 410. The polishing tape 481 extends between a pair of the feed rollers 491 so that the bevel portion of the wafer W is brought into contact with the polishing tape 481. Thus, a polishing surface 481a of the polishing tape 481 is pressed against the notch of the wafer W by a tension of the polishing tape 481 itself. Further, as shown in FIG. 14, a polishing tape supply/recovery mechanism 482 is provided in a machine chamber 458 disposed above the polishing chamber 401 so as to face the sidewall 406. The polishing tape supply/recovery mechanism 482 includes a feed reel 483 a for feeding the polishing tape 481 to the notch polishing head 490 and a takeup reel 483b for recovering the polishing tape 481 from the notch polishing head 490.

The polishing tape 481 is made of the same material as the polishing tape 451 used in the bevel polishing device 450. Since the material and details of the polishing tape 481 are the same as those of the polishing tape 451, details of the polishing tape 481 will not be described repetitively. The polishing tape 481 has a width corresponding to the shape of the notch of the wafer W. The polishing tape 481 has a width smaller than that of the polishing tape 451. The polishing tape 481 is wound around a cylindrical core member 484. The core member 484 is attached to the feed reel 483a. The polishing tape 481 extends between the pair of the feed rollers 491 and 491 in the notch polishing head 490 in a state such that the polishing surface 481a faces outward. Then, the polishing tape 481 is attached to the takeup reel 483b. The takeup reel 483b is coupled to a rotation drive mechanism (not shown) such as a motor. The polishing tape 481 can be wound up and recovered with a predetermined tension applied thereto.

A maintenance hatch 459 is provided over the machine chamber 458 so as to extend upward from the sidewall 406. When the maintenance hatch 459 is opened, an operator is accessible to the polishing tape supply/recovery mechanism 482 from the exterior of the polishing unit 400-1. Thus, the operator can replace the polishing tape 481 with the feed reel 483a and the takeup reel 483b or conduct maintenance operation of the polishing tape supply/recovery mechanism 482.

When the notch polishing head 490 is reciprocated in a vertical direction by the vertical movement mechanism 500, the polishing surface 481a of the polishing tape 481 can be brought into sliding contact with the notch of the wafer W to thereby polish the notch of the wafer W. At that time, the notch polishing head 490 may be swung by the swing mechanism 510 so as to be inclined in the vertical direction at a predetermined angle with respect to the wafer surface. The notch of the wafer W can also be polished in such a state.

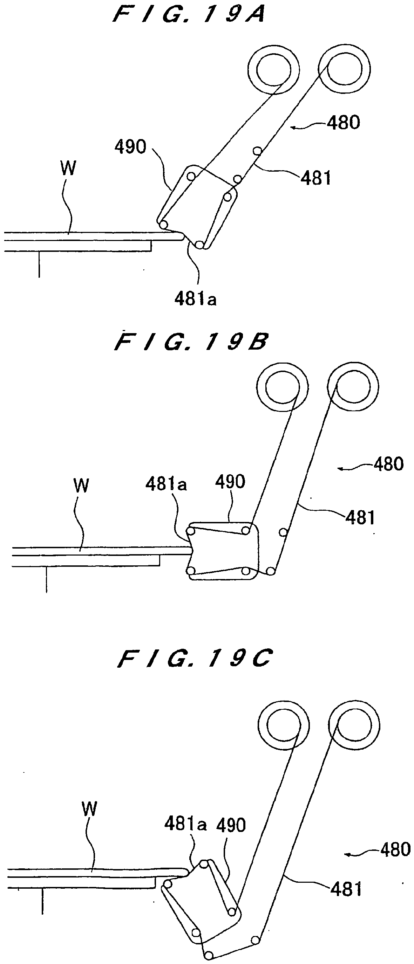

FIGS. 19A through 19C are schematic views explanatory of operation of the notch polishing head 490. By the swing mechanism 510, the polishing surface 481a of the polishing tape 481 can be brought into contact with the polished area on the notch of the wafer W from positions inclined at predetermined angles in the vertical direction with respect to the wafer surface. Accordingly, as shown in FIG. 19A, an upper inclined surface of the notch can be polished in a state such that the notch polishing head 490 is inclined downward at a predetermined angle with respect to the wafer surface. As shown in FIG. 19B, a side surface of the notch can be polished by directing the notch polishing head 490 in a horizontal direction. As shown in FIG. 19C, a lower inclined surface of the notch can be polished in a state such that the notch polishing head 490 is inclined upward at a predetermined angle with respect to the wafer surface. Further, by making fine adjustments to the inclination angle of the notch polishing head 490, the upper and lower inclined surfaces of the notch, the side surface of the notch, and boundaries thereof can be polished along their shapes, or the upper and lower inclined surfaces and the side surface of the notch can be polished so as to have desired angles and shapes.

The polishing unit 400 includes a notch sensor (not shown). For example, the notch sensor may comprise a straight-beam retro-reflective sensor, which includes laser sensor having a light-emitting portion, a light-receiving portion provided at the same portion as the light-emitting portion, and a reflection portion disposed away from the light-emitting portion. If a laser emitted from the light-emitting portion passes through a notch of a wafer, it reaches the reflection portion, reflects from the reflection portion, and returns to the light-receiving portion. Only when the notch passes right below the light-emitting portion, the laser reflects from the reflection portion and returns to the light-receiving portion. Thus, the notch can be detected. If a notch of a wafer W is detected by the notch sensor in a state such that the substrate holding table 411 having the wafer W attracted thereto is rotated, the rotation of the substrate holding table 411 is stopped to align the notch of the wafer W with the polishing tape 481 of the notch polishing device 480.

As shown in FIGS. 13 and 14, the polishing unit 400 has polishing water supply nozzles (first supply nozzles) 523 and 524 disposed near the polishing locations on the upper surface and the lower surface of the wafer W for supplying water (polishing water) such as ultrapure water or pure water. Further, the polishing unit 400 also has a polishing water supply nozzle (second supply nozzle) 525 disposed above the substrate holding table 411 for supplying polishing water to a central area of the upper surface of the wafer W. Pure water is defined as water purified to a high degree for use in semiconductor fabrication. Ultrapure water having a purity higher than pure water or deionized water (DIW) may be used depending on properties of a wafer to be polished and polishing conditions. During polishing the bevel portion and the notch of the wafer W, polishing water is supplied from the polishing water supply nozzles 523 and 524 to prevent particulate polishing wastes, which are caused by polishing, from being attached to the upper surface and the lower surface of the wafer W. Further, it is possible to cool the polishing area and reduce a coefficient of friction during polishing. Polishing water is supplied from the polishing water supply nozzle 525 toward the central area of the wafer W. Since the wafer W held by the substrate holding and rotating mechanism 410 is rotated during polishing, the supplied polishing water flows from the central area of the wafer W toward the outer circumferential portion of the wafer W. Accordingly, the polishing wastes are swept away toward the outer circumferential portion of the wafer W. Further, since the wafer W being polished is horizontally held by the substrate holding and rotating mechanism 410, a water film of the polishing water is formed so as to cover the entire upper surface of the wafer W when the polishing water spreads over the upper surface of the wafer W. Accordingly, even if fine dust floating in a space of the polishing unit 400 falls onto the upper surface of the wafer W, the fine dust is swept away toward the outer circumferential portion of the wafer W by the water film of the polishing water continuously flowing toward the outer circumferential portion of the wafer W. Thus, the fine dust is not attached onto the upper surface of the wafer W. In this manner, the polishing water supplied from the polishing water supply nozzle 525 also serves to prevent dust from being attached to the surface of the wafer W. The lower polishing water supply nozzles 524 are configured to supply polishing water to exposed areas on a rear face of the wafer W which projects radially outward from the substrate holding table 411. When the polishing water is supplied to inner portions of the exposed areas, the supplied polishing wafer flows toward the outer circumferential portion according to rotation of the wafer W, thereby sweeping away polishing wastes toward the outer circumferential portion of the wafer W. Further, as will be described later, it is desirable to use only ultrapure water as polishing water to be supplied to the wafer W in order to prevent contamination of respective components such as the polishing unit 400 and the transfer robot 200B.

The polishing water supplied from the polishing water supply nozzles 523 and 524 serves not only to prevent contamination on the upper and lower surfaces of the wafer W due to polishing wastes but also to remove heat produced by friction during polishing so as to cool the wafer W. Thus, by adjusting the temperature of the polishing water to be supplied, heat can be removed from the polished areas of the wafer W to achieve a stable polishing process.

An endpoint of a polishing process for the peripheral portion of the wafer W by the bevel polishing device 450 may be managed by the polishing time. Alternatively, a temperature variation of the peripheral portion of the wafer W may be monitored, and an endpoint of a polishing process may be detected based on the measured temperature variation. The polishing unit 400 may have a polishing endpoint detection device for detecting an endpoint of the polishing process. Examples of such a polishing endpoint detection device will be described below.

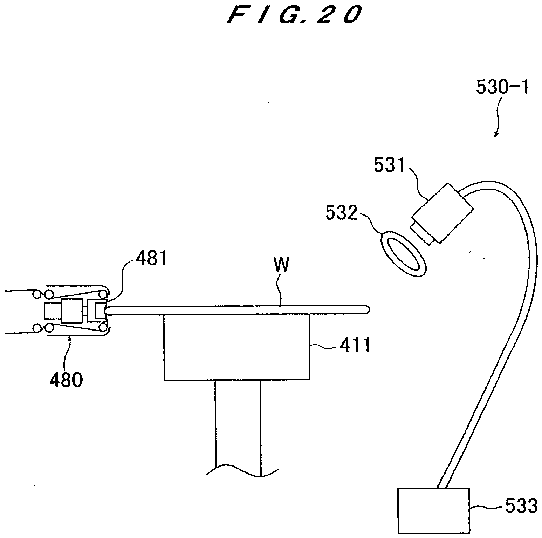

FIG. 20 is a schematic side view showing an example of the polishing endpoint detection device. As shown in FIG. 20, the polishing endpoint detection device 530-1 includes an image sensor 531 of a CCD camera, a lighting ring 532 disposed between the image sensor 531 and a wafer W to be inspected, and a controller 533 connected to the image sensor 531. The controller 533 is operable to capture an image from the image sensor 531 and determine whether or not a polishing process reaches an endpoint.

In the polishing endpoint detection device 530-1, a peripheral portion of a wafer W is lit by the lighting ring 532 during polishing the peripheral portion of the wafer W. The controller 533 captures images from the image sensor 531 and monitors a variation of colors of the peripheral portion of the wafer W to detect a polishing endpoint. When the controller 533 detects a polishing endpoint, the controller 533 sends an endpoint signal to a polishing controller (not shown), which moves the substrate holding table 411 in a horizontal direction to separate the peripheral portion of the wafer W from the polishing tape 481 and stops the rotation of the substrate holding table 411. Before the polishing process, an initial shape of the peripheral portion of the wafer W may be stored in the controller 533 via the image sensor 531. The peripheral portion of the wafer W may be polished so as to maintain the initial shape of the peripheral portion of the wafer W. Factors to determine the initial shape include an inclination angle, a curvature, and a dimension of the peripheral portion of the wafer W. Further, an image of a peripheral portion of a reference wafer that has been polished may previously be stored as a reference image in the controller 533 via the image sensor 531. In this case, images obtained during polishing by the image sensor 531 may be compared with the reference image to detect a polishing endpoint.

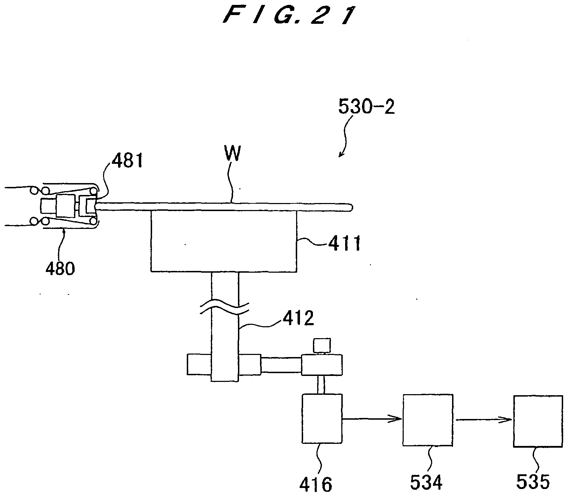

FIG. 21 is a schematic side view showing another example of the polishing endpoint detection device. As shown in FIG. 21, the polishing endpoint detection device 530-2 includes a motor amplifier 534 connected to a motor (servomotor) 416, which rotates the substrate holding table 411, and a controller 535 connected to the motor amplifier 534. The controller 535 is operable to determine from signals amplified by the motor amplifier 534 whether or not a polishing process reaches an endpoint

In the polishing endpoint detection device 530-2, a signal from the motor 416 (e.g., a motor current) rotating the substrate holding table 411, which attracts a wafer under vacuum, at a predetermined speed is amplified by the motor amplifier 534 during polishing a peripheral portion of the wafer W. The amplified signal is sent to the controller 535. The controller 535 calculates a torque required for rotation of the motor 416 based on the signal from the motor amplifier 534. Then, the controller 535 analyzes a variation of the torque to detect a polishing endpoint. When the controller 535 detects a polishing endpoint, the controller 535 sends an endpoint signal to a polishing controller (not shown), which moves the substrate holding table 411 in a horizontal direction to separate the peripheral portion of the wafer W from the polishing tape 481 and stops the rotation of the substrate holding table 411. A torque gauge (not shown) may be provided on the rotational shaft 412 of the substrate holding table 411. A rotation torque of the substrate holding table 411 can directly be detected, and a variation of the rotation torque can be analyzed so as to detect a polishing endpoint. In this case, a varied amount of rotation torque at a polishing endpoint may previously be measured and stored in the controller 535. Measured values can be compared with the stored value to detect a polishing endpoint. Further, a polishing endpoint may be detected by analyzing current variations of the servomotors 428 and 429, which horizontally move the substrate holding table 411.

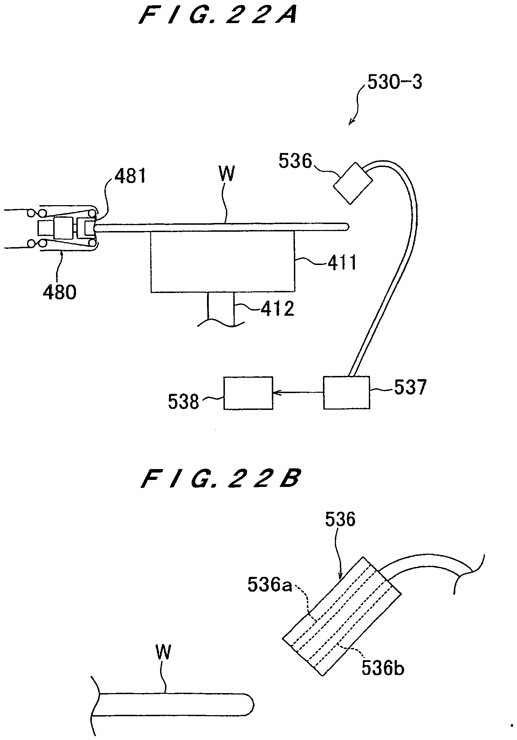

FIG. 22A is a schematic side view showing another example of the polishing endpoint detection device, and FIG. 22B is an enlarged view schematically showing a photosensor 536 of the polishing endpoint detection device 530-3 shown in FIG. 22A. As shown in FIGS. 22A and 22B, the polishing endpoint detection device 530-3 includes a photosensor 536 having a light-emitting portion 536a and a light-receiving portion 536b, a measurement amplifier 537 connected to the photosensor 536, and a controller 538 connected to the measurement amplifier 537. The measurement amplifier 537 is operable to measure and amplify light received by the light-receiving portion 536b of the photosensor 536. The controller 538 is operable to capture a signal amplified by the measurement amplifier 537 and determine whether or not a polishing process reaches an endpoint.

In the polishing endpoint detection device 530-3, a peripheral portion of a wafer W is lit by the light-emitting portion 536a of the photosensor. 536 during polishing the peripheral portion of the wafer W. Scattered light reflected from the peripheral portion is received by the light-receiving portion 536b of the photosensor 536, measured, and amplified by the measurement amplifier 537. The amplified signal is sent to the controller 538. The controller 538 analyzes the scattered light from the signal of the measurement amplifier 537 to evaluate roughness of the polishing state of the peripheral portion of the wafer W. Thus, a polishing endpoint is detected.

The aforementioned polishing endpoint detection device which optically detects a polishing endpoint can also be employed to detect an endpoint of a polishing process of a notch of a wafer W by the notch polishing device 480.

Next, a processing process of a peripheral portion of a wafer in the polishing unit 400 will be described below. A semiconductor wafer W to be polished in the polishing unit 400 has semiconductor devices formed thereon. The wafer W has a diameter of 200 mm or 300 mm. When the air cylinder 405b is actuated, the shutter 405a is lifted to open the opening 405. The wafer W is introduced through the opening 405 into the polishing chamber 401 by the second transfer robot 200B and transferred to above the substrate holding table 411. At that state, when the arms 441 and 441 come close to each other, the holding portions 441a and 441a of the arms 441 and 441 are brought into contact with the peripheral portion of the wafer W. Thus, the holding portions 441a and 441a of the arms 441 and 441 hold the wafer W therebetween and center the wafer W with respect to the substrate holding table 411. Then, the arms 441 and 441 holding the wafer W are lowered to place the wafer. W on the upper surface of the substrate holding table 411. Vacuum is supplied through the vacuum line 436 to the communication passage 432b to attract the wafer onto the upper surface of the substrate holding table 411 under vacuum. At that state, the arms 441 and 441 are horizontally opened to release the wafer W. The arms 441 and 441 are lifted and held at a standby position. Then, the motor 416 is driven to rotate the wafer W together with the substrate holding table 411.

When bevel polishing of the wafer W is to be conducted, the polishing tape supply/recovery mechanism 452 in the bevel polishing device 450 is operated to feed the polishing tape 451 to the bevel polishing head 460 so as to dispose an unused polishing surface 451 a between the feed rollers 461 and 461. The horizontal movement mechanism 423 of the substrate holding and rotating mechanism 410 moves the wafer W toward the bevel polishing head 460 and locates the wafer W at a polishing position of the bevel polishing device 450. The bevel portion of the rotating wafer W is brought into sliding contact with the polishing tape 451 and thus polished. At the time of polishing, the swing mechanism 470 of the bevel polishing device 450 is driven to swing the bevel polishing head 460 around the polishing position. Thus, it is possible to polish not only the bevel portion but also the edge portion of the wafer W. Further, the reciprocation movement mechanism 476 of the bevel polishing device 450 may be driven to reciprocate the bevel polishing head 460 along the tangential direction of the wafer W during polishing.

Instead of driving the swing mechanism 470 or the reciprocation movement mechanism 476 of the bevel polishing device 450, the wafer W may be swung around the polishing position by the swing mechanism provided on the substrate holding and rotating mechanism 410 or may be reciprocated along the tangential direction of the wafer W. When the wafer W is polished while being rotated by the substrate holding and rotating mechanism 410, the substrate holding and rotating mechanism 410 may not be reciprocated.

When notch polishing of the wafer W is to be conducted, the horizontal movement mechanism 423 is operated to move the wafer W to the polishing position of the notch polishing device 480. While the wafer W held by the substrate holding and rotating mechanism 410 is rotated, the notch of the wafer W is detected by the notch sensor. Then, the notch of the wafer W is aligned with a position facing the polishing tape 481 of the notch polishing device 480. The horizontal movement mechanism 423 of the substrate holding and rotating mechanism 410 moves the notch of the wafer W toward the notch polishing head 490 to bring the notch of the wafer W into contact with the polishing tape 481. At that time, the notch polishing head 490 is repeatedly moved in the vertical direction by the vertical movement mechanism 500 of the notch polishing device 480. Thus, the polishing tape 481 is brought into sliding contact with the notch of the wafer W to polish the notch of the wafer W. The notch polishing head 490 may be swung during polishing by the swing mechanism 510 of the notch polishing device 480. In this case, the notch polishing head 490 can be inclined at a predetermined angle with respect to the wafer surface to thereby polish an upper end or lower end of the notch or polish the notch with a desired angle.

When semiconductor devices are formed on the wafer to be polished, the wafer may have submicronic fine irregularities formed in the surface of the wafer. If abrasive particles are separated from the polishing tape during polishing such a wafer, then the separated abrasive particles enter recesses formed in the surface of the wafer. In such a case, even if the wafer is cleaned in a cleaning process subsequent to the polishing process, the abrasive particles cannot sufficiently be removed from the recesses in the wafer. According to the present embodiment, the aforementioned polishing tapes 451 and 481 are used to bring polishing layers (polishing surfaces 451a and 481a) of the polishing tapes 451 and 481 into sliding contact with the peripheral portion (bevel portion and notch) of the wafer W at the polishing positions in the polishing unit 400-1. Therefore, abrasive particles are prevented from being readily separated and entering recesses formed in the wafer W. Particularly, even if resin material of the polishing tape is exposed to water, abrasive particles are not readily separated. Accordingly, even if the wafer W is polished while polishing water of ultrapure water is supplied onto the surface of the wafer W, the abrasive particles are prevented from being readily separated and entering recesses formed in the wafer W.

In the polishing unit 400-1, the wafer W is polished while polishing water of ultrapure water is supplied onto the surface of the wafer W from the polishing water supply nozzles 523, 524, and 525. As described above, ultrapure water spreads over the surface of the wafer W, which is horizontally held and rotated by the substrate holding and rotating mechanism 410. Thus, ultrapure water serves to cover the entire surface of the wafer W so as to protect the surface of the wafer W and to remove frictional heat produced by friction between the polishing layers of the polishing tapes 451 and 481 and the wafer W. In this case, separate lines may be used for supplying ultrapure water to protect the surface of the wafer W and for supplying ultrapure water to remove heat and cool the wafer W during polishing.

Further, if slurry other than pure water is supplied for polishing the wafer W, the hand of the transfer robot 200B may be contaminated by slurry attached to the wafer W when the wafer W is transferred from the polishing unit 400-1 to the primary cleaning unit 600 by the transfer robot 200B after the polishing. In the present embodiment, if slurry is not used but only ultrapure water is used as polishing water supplied for polishing in the polishing unit 400-1, then the hand of the transfer robot 200B and other units are prevented from being contaminated by the polished wafer W.

Further, when the slurry is supplied during polishing in the polishing unit 400-1, the slurry contaminates the bevel polishing head 480 and the notch polishing head 490 in the polishing unit 400-1 and the respective components in the polishing unit 400-1. In such a case, an operator should be accessible to the polishing unit 400-1 not only through the maintenance hatches 407 and 408 but also in other directions at the time of cleaning of the polishing unit 400-1, i.e., at the time of maintenance of the polishing unit 400-1. Thus, maintenance operation becomes a heavy load on an operator. However, when only ultrapure water is supplied during polishing, the respective components of the polishing unit 400-1 are not contaminated. Accordingly, it becomes unnecessary to clean comtaminated portions. The operator can conduct maintenance operation only through the maintenance hatches 407 and 408. Thus, a load on the operator can be reduced.

Further, the wafer W is moved to the position for the bevel polishing device 450, and the peripheral portion of the wafer W is polished by the bevel polishing device 450. Then, the wafer W may be moved from the position for the bevel polishing device 450 to the position for the notch polishing device 480 by the horizontal movement mechanism 423 while ultrapure water is continuously supplied from the polishing water supply nozzle 525 onto the surface of the wafer W. Alternatively, the wafer W may be moved from the position for the notch polishing device 480 to the position for the bevel polishing device 450 while ultrapure water is continuously supplied from the polishing water supply nozzle 525 onto the surface of the wafer W. In this case, the wafer W is moved while the surface of the wafer W is covered with a wafer film. Accordingly, the wafer W is prevented from being contaminated by an atmosphere or polishing wastes in the polishing unit 400-1. Thus, it is possible to maintain a cleanliness of the wafer W. Further, it is possible to prevent secondary contamination of the bevel polishing device 450 or the notch polishing device 480 where the wafer is to be transferred. Therefore, polishing can be conducted without hindrance in the bevel polishing device 450 or the notch polishing device 480. Since it is also possible to maintain a cleanliness of the respective components in the polishing unit 400-1, loads of maintenance operation such as cleaning can be reduced.

During polishing, it is desirable that the polishing chamber 401 is evacuated via a vacuum line (not shown) connected to the polishing chamber 401 so as to reduce an (air) pressure in the polishing chamber 401 to be lower than an (air) pressure outside of the polishing chamber 401. In such a case, polishing powder or particles scattering in the polishing chamber 401 can be discharged into the exterior of the polishing chamber 401. Accordingly, the polishing chamber 401 can be maintained in a clean state. Further, it is possible to prevent polishing powder from flowing into an area that is required to have a high cleanliness. When the polishing endpoint detection device detects a polishing endpoint of the wafer W, polishing is completed in the bevel polishing device 450 or the notch polishing device 480. When all polishing processes are completed, the arms 441 and 441 are lowered from the standby positions to hold the wafer W. The vacuum attraction of the substrate holding and rotating mechanism 410 is released. Then, the arms 441 and 441 holding the wafer W are lifted to predetermined positions, and the shutter 405a is opened. The hand of the second transfer robot 200B is introduced into the polishing chamber 401 to receive the wafer W held by the arms 441 and 441. The second transfer robot 200B transfers the wafer W from the polishing chamber 401.

### 6. Second Embodiment of Polishing Unit

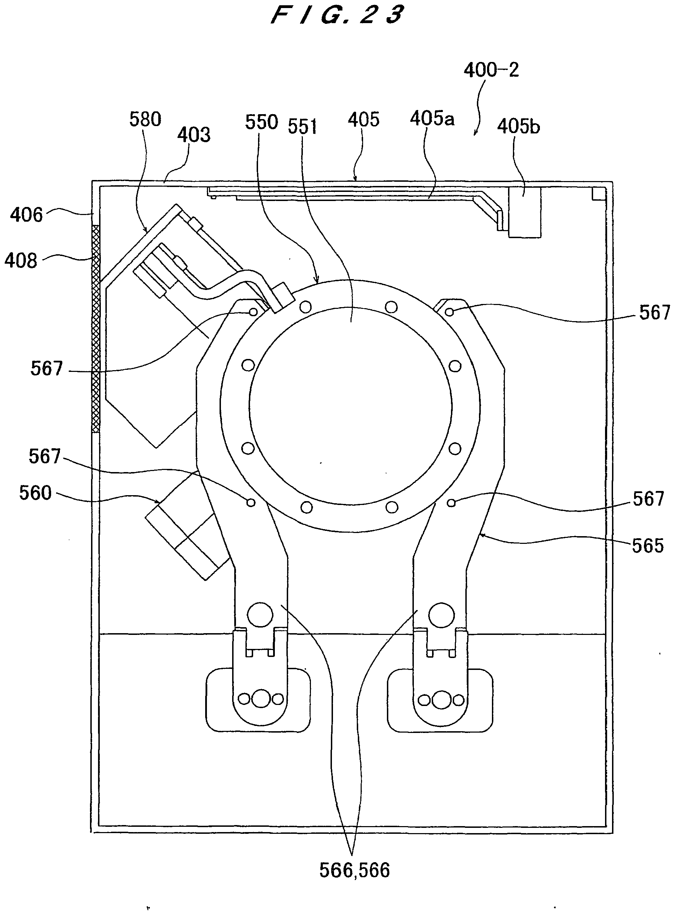

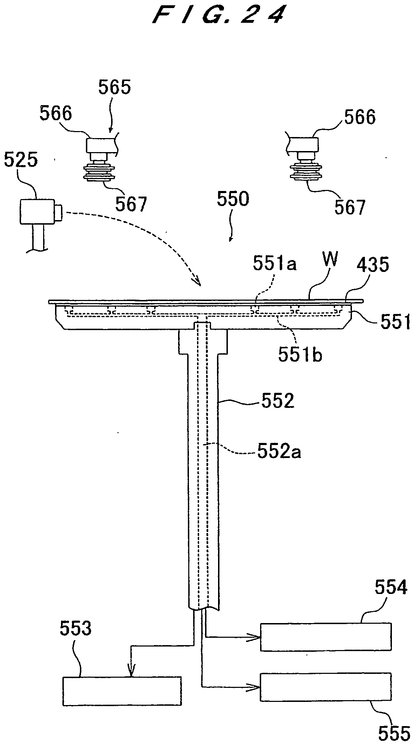

Another example of the polishing unit 400 will be described below. FIG. 23 is a schematic plan view of a polishing unit 400-2 according to a second embodiment of the present invention. FIG. 24 is a cross-sectional side view schematically showing a portion of the polishing unit 400-2 shown in FIG. 23. In the polishing unit 400-2, similar portions to those of the polishing unit 400-1 are denoted by the same reference numerals and will not be described repetitively. The following description relates mainly to differences between the polishing unit 400-2 and the polishing unit 400-1.

The polishing unit 400-2 has a substrate holding and rotating mechanism 550 for holding and rotating a wafer, a substrate transfer mechanism 565 for receiving, centering, and delivering the wafer, a bevel polishing device 560 for polishing a bevel portion of the wafer, a notch polishing device 580 for polishing a notch of the wafer, and a notch sensor (not shown) for detecting the notch of the wafer.

As shown in FIG. 24, the substrate holding and rotating mechanism 550 includes a substrate holding table 551 having attraction grooves 551a for attracting the wafer W under vacuum and a rotational shaft 552 for supporting and rotating the substrate holding table 551. The rotational shaft 552 is coupled to a rotation drive device 553. The rotation drive device 553 rotates the rotational shaft 552 together with the substrate holding table 551. The grooves 551a in the substrate holding table 551 communicate with communication passages 551b formed in the substrate holding table 551. The communication passages 551b communicate with a communication passage 552a formed within the rotational shaft 552. The communication passage 552a is connected to a vacuum line 554 and a compressed air supply line 555. The substrate holding table 551 and the rotational shaft 552 are coupled to a vertical movement mechanism (not shown) for lifting the substrate holding table 551 when the wafer W is received from the substrate transfer mechanism 565 and delivered to the substrate transfer mechanism 565. The substrate holding table 551 has a polishing pad 435 attached on an upper surface of the wafer W.

The substrate transfer mechanism 565 disposed above the substrate holding and rotating mechanism 550 has a pair of arms 566 and 566. Each of the arms 566 and 566 includes a plurality of chucks 567 having a recessed surface corresponding to a bevel portion of the wafer W. The arms 566 and 566 are capable of opening and closing and can have a close position and a release position. The arms 566 and 566 can sandwich the wafer W between the chucks 567 and 567 at the close position and can release the wafer W at the release position. When the wafer W is clamped by the arms 566 and 566, the wafer W is centered.

The substrate holding and rotating mechanism 550 is lowered to a predetermined position after receiving the wafer W from the substrate transfer mechanism 565. Then, vacuum is supplied via the vacuum line 554 to attract the wafer onto the upper surface of the substrate holding table 551 under vacuum. The rotation drive device 553 is driven to rotate the wafer W at a predetermined rotational speed.

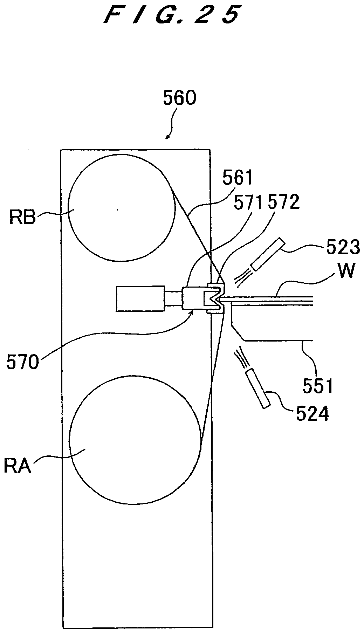

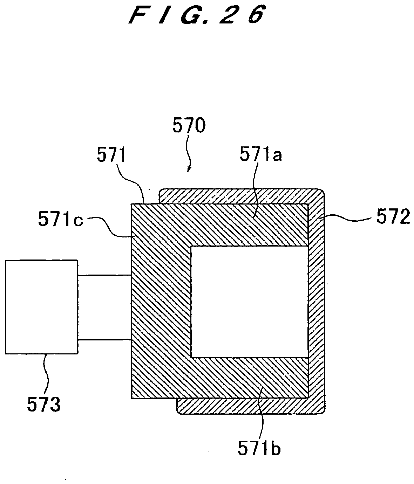

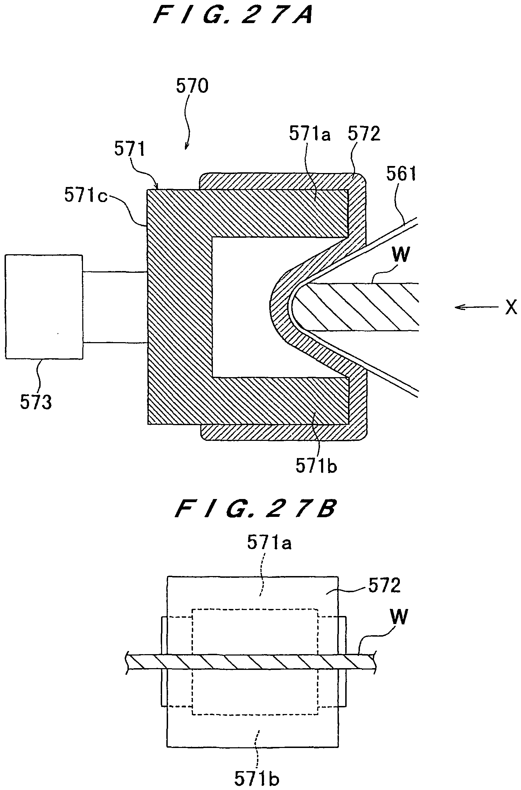

FIG. 25 is a schematic side view of the bevel polishing device 560, and FIG. 26 is a partial enlarged view showing a bevel polishing head 570 in the bevel polishing device 560. FIG. 27A is schematic view showing the bevel polishing head 570 at the time of polishing, and FIG. 27B is a view as seen from a direction X of FIG. 27A. As shown in FIGS. 25 and 26, the bevel polishing device 560 has a bevel polishing head 570 for pressing a polishing tape 561 against a bevel portion of the wafer W. The bevel polishing head 570 includes a support member 571 having two projections 571a and 571b and an elastic member 572 extending between ends of the projections 571a and 571b. For example, the elastic member 572 is made of elastic rubber. The bevel polishing head 570 is movable in a radial direction of the wafer W by a movement mechanism (not shown). An air cylinder 573 is coupled to a base 571c of the support member 571. When the air cylinder 573 is operated, as shown in FIG. 27A, the support member 571 is moved toward the center of the wafer W so as to press the polishing tape 561 against the bevel portion of the wafer W via the elastic member 572. The bevel polishing device 560 may have a mechanism for adjusting a distance between the projections 571a and 571b of the support member 571. The polishing tape 561 is housed in a cassette tape cartridge (not shown). As shown in FIG. 25, the polishing tape 561 is wound up with a certain tension by a takeup reel RA and a feed reel RB in the cassette tape cartridge.

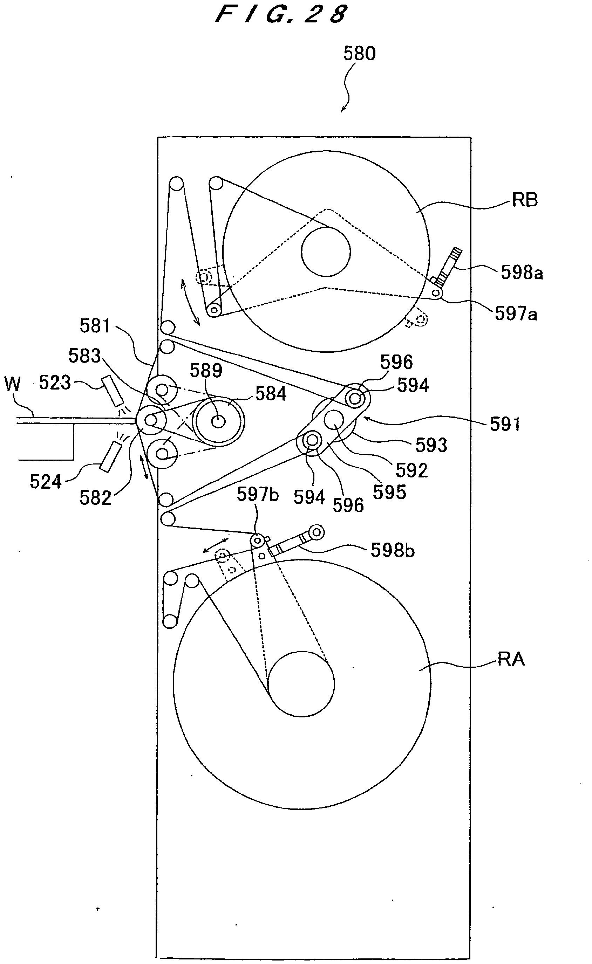

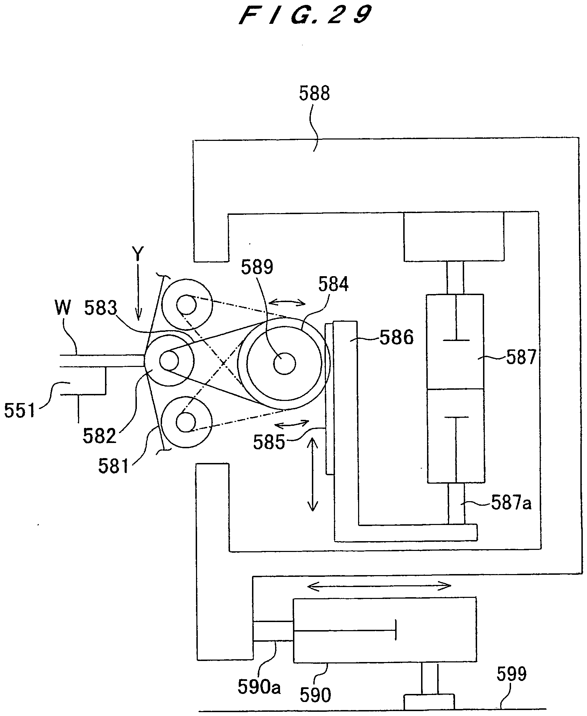

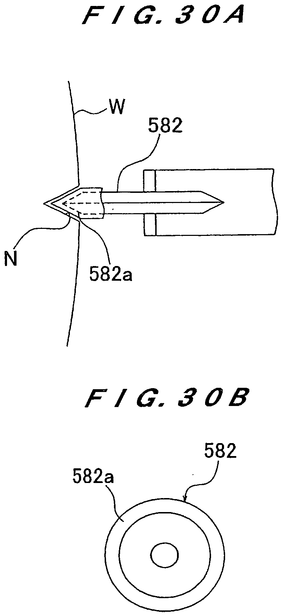

FIG. 28 is a schematic side view showing the notch polishing device 580, and FIG. 29 is a schematic side view showing a drive mechanism in the notch polishing device 580. FIG. 30A is a view as seen from a direction Y of FIG. 29, and FIG. 30B is a side view of an elastic roller 582 for pressing a polishing tape 581 against the notch of the wafer W. As shown in FIGS. 28 and 29, the notch polishing device 580 has an elastic roller 582 for pressing a polishing tape 581 against the notch of the wafer W. The elastic roller 582 is rotatably supported by a support arm 583. A gear 584 is fixed to an end of the support arm 583. As shown in FIGS. 30A and 30B, the elastic roller 582 is in the form of a disk made of silicon rubber or the like. The elastic roller 582 has a tapered outer circumferential portion 582a. Specifically, the outer circumferential portion 582a of the elastic roller 582 has a tapered shape corresponding to the notch N of the wafer W and fits into the notch N of the wafer W.

The gear,584 engages with a rack 585, which is fixed to an L-shaped support member 586. The support member 586 is coupled to a rod 587a of an air cylinder 587. The support arm 583 is supported by a support frame 588 so as to be pivotable about a rotational shaft 589. The air cylinder 587 has an upper end fixed to the support frame 588. An air cylinder 590 is fixed to a frame 599 fixed onto a fixed portion such as a base of the apparatus. The support frame 588 is fixed to a rod 590a of the air cylinder 590. The polishing tape 581 is housed in a cassette tape cartridge (not shown). As shown in FIG. 28, the polishing tape 581 is wound up with a certain tension by a takeup reel RA and a feed reel RB in the cassette tape cartridge.

As shown in FIG. 28, the bevel polishing device 560 has a tape drive mechanism 591 provided between the takeup reel RA and the feed reel RB for reciprocating the polishing tape 581 during polishing. The tape drive mechanism 591 includes a gear 593 rotatable about an axis 592, a pair of rotatable gears 594 and 594 engaged with the gear 593, and a support lever 595 for supporting the pair of gears 594 and 594. The gear 593 is coupled to a servomotor (not shown). The gears 594 and 594 are disposed above and below the gear 593. When the gear 593 is rotated by the servomotor, the gears 594 and 594 rotate about their axes and roll on a circumference of the gear 593. As a result, the support lever 595 is swung about the axis 592. The support lever 595 has a pair of support rollers 596 and 596. The polishing tape 581 is wound around the upper and lower support rollers 596 and 596. In FIG. 28, the upper gear 594 and the upper support roller 596 are illustrated as the same component, and the lower gear 594 and the lower support roller 596 are illustrated as the same component. However, the gears 594 are disposed behind the support rollers 596 and the support lever 595 and may not be illustrated in FIG. 28.

When the gear 593 is rotated counterclockwise by the servomotor, the gears 594 and 594 rotate clockwise while the support lever 595 is swung counterclockwise about the axis 592. Thus, the polishing tape 581 is drawn toward the takeup reel RA. When the gear 593 is rotated clockwise by the servomotor, the gears 594 and 594 rotate counterclockwise while the support lever 595 is swung clockwise about the axis 592. Thus, the polishing tape 581 is drawn toward the feed reel RB. A reciprocation stroke of the polishing tape 581 is absorbed by idle rollers 597a and 597b provided at an upper portion and a lower portion, respectively. The idle rollers 597a and 597b are movable in directions of arrows. The upper and lower idle rollers 597a and 597b are biased by an upper tension 598a and a lower tension 598b of extension coil springs, respectively. When the polishing tape 581 is vertically reciprocated by the servomotor, the takeup reel RA and the feed reel RB are locked by a lock mechanism. Since the polishing tape 581 is vertically reciprocated by the servomotor, a relative speed can be adjusted between a surface to be polished and the polishing tape 581. Thus, a polishing rate can readily be adjusted.

The notch of the wafer is polished by the notch polishing device 580 as follows. When the notch of the wafer W is detected by the notch sensor and aligned with the elastic roller 582 of the notch polishing device 580, operation of the notch polishing device 580 is started. In the notch polishing device 580, when the air cylinder 587 is operated to move the rod 587a upward, the rack 585 fixed to the support member 586 is also moved upward to rotate the gear 584 counterclockwise. As a result, the support arm 583 is pivoted downward about the rotational shaft 589 to move the elastic roller 582 to a lower position. When the air cylinder 587 is operated to move the rod 587a downward, the rack 585 fixed to the support member 586 is also moved upward to rotate the gear 584 clockwise. As a result, the support arm 583 is pivoted upward about the rotational shaft 589 to move the elastic roller 582 to an upper position. The air cylinder 587 can move the rod 587a to three positions including an upper position, a lower position, and an intermediate position. The air cylinder 590 is operated to move the support frame 588 forward so that the elastic roller 582 is moved toward the wafer W. Thus, the polishing tape 581 is pressed against the notch N of the wafer W by the elastic roller 582.

At that time, the wafer W is attracted onto the substrate holding table 551 under vacuum, and rotation of the substrate holding table 551 is stopped in a stationary state. The servomotor is driven to swing the support lever 595 of the tape drive mechanism 591, so that the polishing tape 581 is vertically reciprocated. Accordingly, the polishing tape 581 is brought into sliding contact with the notch of the wafer W to polish the notch of the wafer W. A pressure to press the polishing tape 581 against the notch can be adjusted by properly adjusting a pressure of compressed air to be supplied to the air cylinder 590. Further, polishing water is supplied to the notch of the wafer W and a contacting portion of the polishing tape 581 from polishing water supply nozzles 523 and 524. Thus, the notch of the wafer W is polished in a wet state. A worn polishing tape 581 is wound up before a polishing rate of the tape is lowered, so that a new polishing tape 581 is brought into contact with the wafer W.

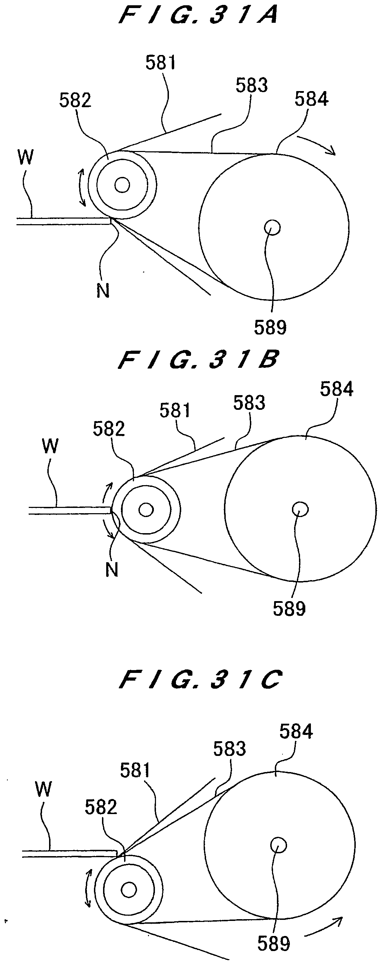

FIGS. 31A through 31C are schematic views showing a relationship between the notch polishing device 580 and the wafer W during polishing of the notch of the wafer W. FIG. 31A shows that an upper edge portion of the notch is polished. FIG. 31B shows that a side surface of the notch is polished. FIG. 31C shows that a lower portion of the notch is polished. When an upper edge portion of the notch N of the wafer W is to be polished, the air cylinder 587 is operated to move the rod 587a to the lower position in the notch polishing device 580. At that time, the gear 584 is rotated clockwise, and the support arm 583 is pivoted upward about the rotational shaft 589 to move the elastic roller 582 to the upper position. Then, the air cylinder 590 is operated to move the support frame 588 forward (see FIG. 30). Thus, the elastic roller 582 is moved toward the wafer W. As shown in FIG. 31A, the polishing tape 581 is pressed against the upper edge portion of the notch N of the wafer W by the elastic roller 582. The polishing tape 581 is vertically reciprocated to polish the upper edge portion of the notch N.

When the side surface of the notch of the wafer W is to be polished, the air cylinder 587 is operated to move the rod 587a to the intermediate position. At that time, the support arm 583 is held substantially in a horizontal state. The air cylinder 590 is operated to move the support frame 588 forward (see FIG. 30). Thus, the elastic roller 582 is moved toward the wafer W. As shown in FIG. 31B, the polishing tape 581 is pressed against a radial outer periphery of the notch N of the wafer W by the elastic roller 582. The polishing tape 581 is vertically reciprocated to polish the radially outer periphery of the notch N.

When a lower edge portion of the notch N of the wafer W is to be polished, the air cylinder 587 is operated to move the rod 587a to the upper position. At that time, the gear 584 is rotated counterclockwise, and the support arm 583 is pivoted downward about the rotational shaft 589 to move the elastic roller 582 to the lower position. Then, the air cylinder 590 is operated to move the support frame 588 forward (see FIG. 30). Thus, the elastic roller 582 is moved toward the wafer W. As shown in FIG. 31C, the polishing tape 581 is pressed against the lower edge portion of the notch N of the wafer W by the elastic roller 582. The polishing tape 581 is vertically reciprocated to polish the lower edge portion of the notch N.

Thus, according to the notch polishing device 580, it is possible to polish the upper edge portion, the outer periphery, and the lower edge portion of the notch N of the wafer. Thus, ideal polishing corresponding to the shape of the notch can be conducted.

### 7. Arrangement of First and Second Polishing Units

Arrangements of the first and second polishing units 400A and 400B in the substrate processing apparatus 1 will be described below. As shown in FIG. 2, the first and second polishing units 400A and 400B, which have the same components, are disposed on both sides of a corner portion 3e of the housing 3 in the substrate processing apparatus 1 with interposing the corner portion 3e therebetween. Plane arrangements of internal components in the first and second polishing units 400A and 400B are axisymmetric with respect to the center line L between the polishing units 400A and 400B. Specifically, the second polishing unit 400B has a plane arrangement into which a plane arrangement of the first polishing unit 400A is reversed with respect to the central line L as an axis. More specifically, the shapes of the frames 403A and 403B of the first polishing unit 400A and the second polishing unit 400B are axisymmetric with respect to the center line L. Further, the same components including the substrate holding and rotating mechanisms 410A, 410B, the bevel polishing devices 450A, 450B, the notch polishing devices 480A, 480B, and the substrate transfer mechanism 440A, 440B are disposed in the first polishing unit 400A and the second polishing unit 400B so as to be axisymmetric with respect to the center line L. Furthermore, with regard to the bevel polishing device 450A, 450B and the notch polishing devices 480A, 480B, operation directions are also symmetric on the horizontal plane with respect to center line L. Specifically, the first polishing unit 400A and the second polishing unit 400B are programmed to rotate wafers W in opposite directions during polishing bevel portions of the wafers.

The first and second polishing units 400A and 400B are provided so as to surround a central area of the substrate processing apparatus 1, in which the second transfer robot 200B is disposed. Openings 405A and 405B for transfer of wafers in the first and second polishing units 400A and 400B face the second transfer robot 200B, respectively. With such an arrangement, the second transfer robot 200B is accessible to both of the first and second polishing units 400A and 400B. Further, the second transfer robot 200B is disposed substantially on an extension of the center line L. Accordingly, the arrangements of the first and second polishing units 400A and 400B are symmetric as seen from the second transfer robot 200B. Specifically, as seen from the second transfer robot 200B, the bevel polishing device 450A is disposed on the left side of the opening 405A in the first polishing unit 400A, and the bevel polishing device 450B is disposed on the right side of the opening 405B in the second polishing unit 400B.

A maintenance space 7 is formed in front of the corner portion 3e of the substrate processing apparatus 1, which is interposed between the first and second polishing units 400A and 400B. An operator can enter the maintenance space 7 from the exterior of the substrate processing apparatus 1. The maintenance space 7 is substantially rectangular in a plan view. The maintenance space 7 is surrounded by two sides facing a sidewall 404A, near which the bevel polishing device 450A is disposed in the first polishing unit 400A, and a sidewall 404B, near which the bevel polishing device 450B is disposed in the second polishing unit 400B, and by two sides facing sidewalls 3b and 3c, which interpose the corner portion 3e of the substrate processing apparatus 1. An entrance 8 is provided on the sidewall 3b at a position facing the maintenance space 7. The operator can enter the maintenance space 7 through the entrance 8 from the exterior of the substrate processing apparatus 1.

Specifically, the maintenance space 7 faces the maintenance hatches 407A and 407B, which are provided in the sidewalls 404A and 404B of the first and second polishing units 400A and 400B, respectively. After an operator enters the maintenance space 7, the operator can open the maintenance hatch 407A or 407B so as to replace a polishing tape or a polishing pad in the bevel polishing device 450A or 450B. Thus, since the operator is accessible to the bevel polishing devices 450A and 450B in the first and second polishing units 400A and 400B from the same maintenance space 7, polishing tapes or the like can be replaced all at once in both of the bevel polishing devices 450A and 450B.

Further, the maintenance space 7 faces the maintenance hatch.457 for the machine chamber 456 (see FIG. 13), which houses the polishing tape supply/recovery mechanism 452 of each of the first polishing unit 400A and the second polishing unit 400B. Accordingly, by opening the maintenance hatch 457 at the maintenance space 7, the polishing tape 451 can readily be replaced together with the reels. Further, the maintenance space 7 faces the spacing section 495 (see FIG. 13) for connecting pipes or wires between the substrate processing apparatus 1, the first polishing unit 400A, and the second polishing unit 400B. Accordingly, connection of pipes or wires can be conducted from the maintenance space 7. Thus, operation for connection is facilitated. Therefore, maintenance of the first and second polishing units 400A and 400B can be effectively conducted in a short period of time. Thus, it is possible to improve maintenance performance of the substrate processing apparatus 1.

Further, the spacing sections 495 of the first polishing unit 400A and the second polishing unit 400B are collectively disposed at positions facing the maintenance space 7. Accordingly, it is possible to shorten pipes branched from pipes of the substrate processing apparatus 1 into the polishing units 400A and 400B. Thus, it is possible to reduce pressure loss of liquid or gas flowing through the pipes. As a result, the branched pipes can have a small diameter and thus achieve good management of piping connection.

The notch polishing device 480A is disposed near the sidewall 406A, which faces the sidewall 3c of the substrate processing apparatus 1, in the first polishing unit 400A. The maintenance hatch 408A is provided in the sidewall 406A. The maintenance hatch 10 is also provided in the sidewall 3c at a position facing the sidewall 406A. Thus, when an operator opens the maintenance hatch 10 of the substrate processing apparatus 1 from the exterior of the substrate processing apparatus 1 and the maintenance hatch 408A of the first polishing unit 400A, the operator becomes accessible to the notch polishing device 480A and can conduct maintenance operation of the notch polishing device 480A.

The notch polishing device 480B is disposed near the sidewall 406B, which faces the sidewall 3b of the substrate processing apparatus 1, in the second polishing unit 400B. The maintenance hatch 408B is provided in the sidewall 406B. The maintenance hatch 9 is also provided in the sidewall 3b at a position facing the sidewall 406B. Thus, when an operator opens the maintenance hatch 9 of the substrate processing apparatus 1 from the exterior of the substrate processing apparatus 1 and the maintenance hatch 408B of the second polishing unit 400B, the operator becomes accessible to the notch polishing device 480B and can conduct maintenance operation of the notch polishing device 480B.

The maintenance hatches 459 of the machine chambers 458 (see FIG. 14) in the first and second polishing units 400A and 400B face the sidewall 3b and the sidewall 3c, respectively. Accordingly, when an operator opens the maintenance hatch 9 or 10 in the sidewall 3b or 3c and the maintenance hatch 459, the operator becomes accessible to the polishing tape supply/recovery mechanism 482 in the first polishing unit 400A or the second polishing unit 400B, so that the polishing tape 481 can readily be replaced together with reels. Thus, maintenance operation such as replacement of the polishing tapes in the notch polishing devices 480A and 480B can be conducted from the exterior of the substrate processing apparatus 1. Accordingly, an operator is not required to enter the interior of the substrate processing apparatus 1, and convenience of maintenance can be improved.

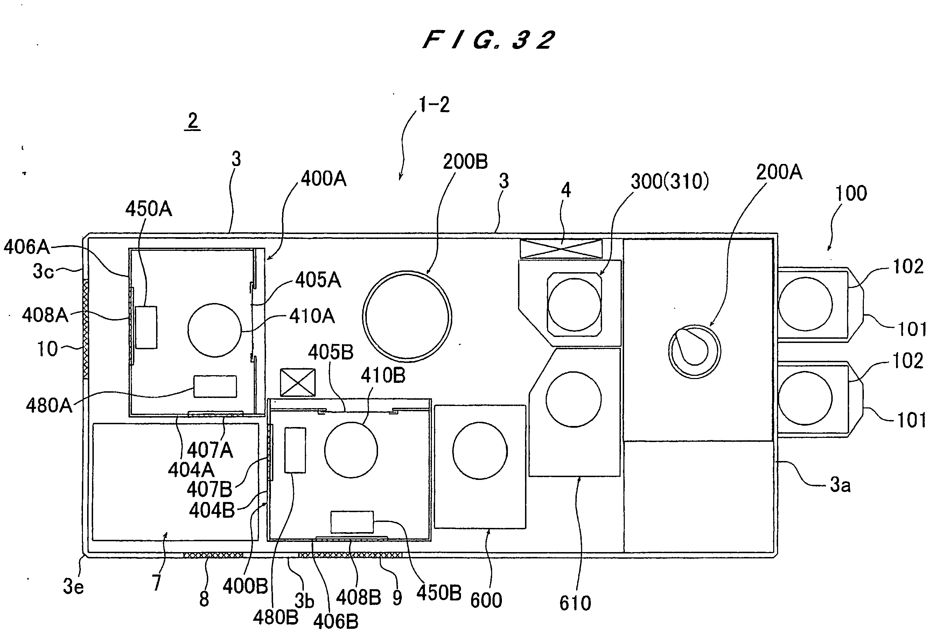

FIG. 32 is a schematic plan view showing another arrangement of the polishing units 400A and 400B in the substrate processing apparatus. The substrate processing apparatus 1-2 shown in FIG. 32 has a reversed arrangement of the bevel polishing devices 450A, 450B, the notch polishing devices 480A, and 480B to those of the polishing units 400A and 400B in the substrate processing apparatus 1 shown in FIG. 2. Specifically, as shown in FIG. 32, the notch polishing devices 480A and 480B are disposed near the sidewalls 404A and 404B of the polishing units 400A and 400B, respectively, which face the maintenance space 7. In this case, an operator is accessible to the notch polishing devices 480A and 480B in the first and second polishing units 400A and 400B from the maintenance space 7. Further, the bevel polishing device 450A may be disposed near the sidewall 404A of the polishing unit 400A which faces the maintenance space 7, and the notch polishing device 480B may be disposed near the sidewall 404B of the polishing unit 400B which faces the maintenance space 7. Alternatively, the notch polishing device 480A may be disposed near the sidewall 404A of the polishing unit 400A which faces the maintenance space 7, and the bevel polishing device 450B may be disposed near the sidewall 404B of the polishing unit 400B which faces the maintenance space 7. Thus, the bevel polishing device 450 and the notch polishing device 480 in the polishing units 400A and 400B may be disposed so as to face the maintenance space 7. In such a case, either the bevel polishing device 450 or the notch polishing device 480 may be disposed near the sidewalls 406A and 406B of the polishing units 400A and 400B. Further, both of the bevel polishing device 450A and the notch polishing device 480A may be disposed near the sidewall 404A in the polishing unit 400A which faces the maintenance space 7. Both of the bevel polishing device 450B and the notch polishing device 480B may be disposed near the sidewall 404B of the polishing unit 400B which faces the maintenance space 7. Thus, both of the bevel polishing device 450B and the notch polishing device 480B can be disposed near one of the sidewalls of the polishing unit 400. With such an arrangement, an operator is accessible to both of the bevel polishing device 450 and the notch polishing device 480 from a maintenance hatch provided in one sidewall. Accordingly, it is possible to facilitate maintenance operation such as replacement of the polishing tapes.

### 8. Primary Cleaning Unit

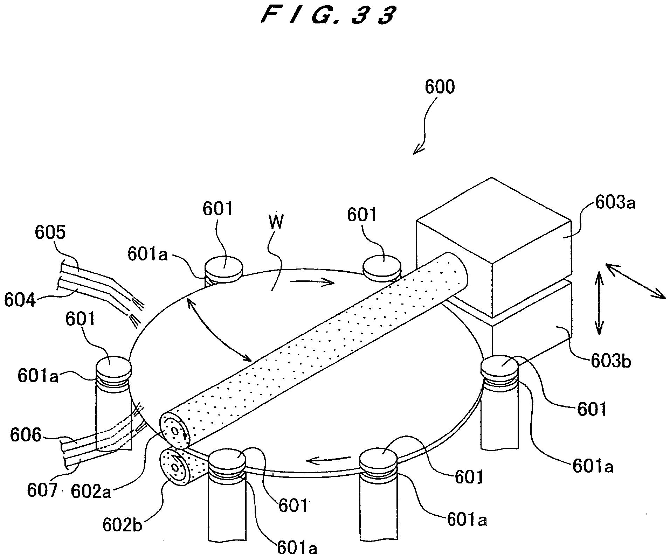

Next, an arrangement of the primary cleaning unit 600 will be described below. FIG. 33 is a schematic perspective view showing the primary cleaning unit 600. As shown in FIG. 33, the primary cleaning unit 600 comprises a roll/roll (R/R) slow-rotation cleaning unit. Specifically, the primary cleaning unit 600 has a plurality of spindles 601 for holding a peripheral portion of a wafer W and a pair of roll-type cleaning members (roll sponges) 602a and 602b disposed above and below the wafer W held by the spindles 601. The spindles 601 are used as holding members each having a rotation mechanism. As shown in FIG. 33, a plurality of spindles 601 (six spindles in the illustrated example) are provided so as to surround the wafer W. Each of the spindles 601 can be moved inward and outward with respect to the wafer W by a drive mechanism (not shown). Each of the spindles 601 has a holding groove 601a formed in a side surface near an upper end thereof. The outer circumferential portion of the wafer W is engaged with the holding grooves 601a so that the wafer W is held by the spindles 601. The spindles 601 can be rotated by a rotation mechanism (not shown). When the spindles 601 are rotated in the same direction, the wafer W held by the spindles 601 is rotated.

The cleaning members 602a and 602b are attached to the drive mechanisms 603a and 603b, respectively. The cleaning members 602a and 602b can be rotated about their axes and moved in a vertical direction by the drive mechanisms 603a and 603b, respectively. The cleaning members 602a and 602b can be moved downward and upward so as to be brought into contact with the upper and lower surfaces of the wafer W to be cleaned, respectively. When the wafer W is transferred into and from the primary cleaning unit 600, the cleaning members 602a and 602b can be retracted upward and downward, respectively. The primary cleaning unit 600 includes a chemical liquid supply nozzle 604 for supplying an etching liquid (chemical liquid) onto the upper surface (front face) of the wafer W, a cleaning liquid supply nozzle 605 for supplying a cleaning liquid (pure water) onto the upper surface (front face) of the wafer W, a chemical liquid supply nozzle 606 for supplying an etching liquid (chemical liquid) onto the lower surface (rear face) of the wafer W, and a cleaning liquid supply nozzle 607 for supplying a cleaning liquid onto the lower surface (rear face) of the wafer W.

A cleaning process of the primary cleaning unit 600 will be described. When a wafer W is transferred to the primary cleaning unit 600, the wafer W is held and rotated by the spindles 601. Simultaneously, the cleaning members 602a and 602b are moved downward and upward so that they are brought into contact with the upper and lower surfaces of the wafer W. At that state, while the cleaning members 602a and 602b are rotated, they are brought into sliding contact with the upper and lower surfaces of the wafer W. The cleaning liquid supply nozzles 605 and 607 supply cleaning liquids onto the upper and lower surfaces of the wafer W to scrub and clean the entire areas of the upper and lower surfaces of the wafer W.

After the scrubbing, the cleaning members 602a and 602b are retracted upward and downward. The chemical liquid supply nozzles 604 and 606 supply etching liquids onto the upper and lower surfaces of the wafer W to etch (chemically clean) the upper and lower surfaces of the wafer W. Thus, remaining metal ions are removed. At that time, the rotational speed of the spindles 601 to rotate the wafer W is varied as needed. Then, the cleaning liquid supply nozzles 605 and 607 supply cleaning liquids (pure water) onto the upper and lower surfaces of the wafer W to perform replacement with pure water for a predetermined periods of time. Thus, the etching liquids are removed from the upper and lower surfaces of the wafer W. At that time, the rotational speed of the spindles 601 to rotate the wafer W is varied as needed.

### 9. Secondary Cleaning and Drying Unit

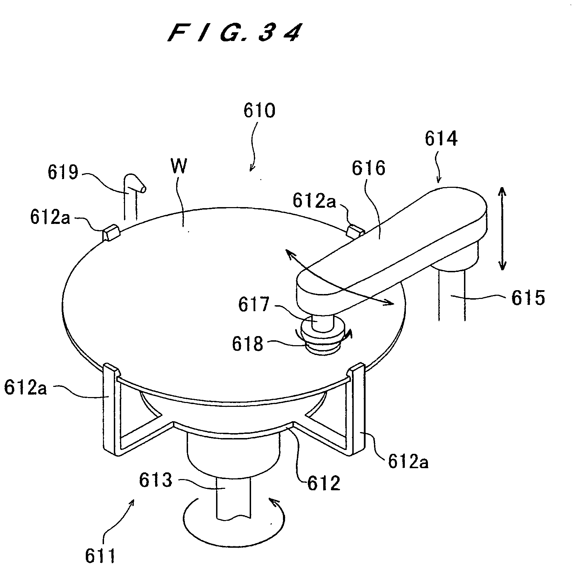

Next, an arrangement of the secondary cleaning and drying unit 610 will be described below. FIG. 34 is a schematic view showing a spin-dry unit having a cleaning function as the secondary cleaning and drying unit 610. The spin-dry unit 610 shown in FIG. 34 has a substrate holding and rotating mechanism 611, a pencil-type cleaning mechanism 614, and a cleaning liquid supply nozzle 619. The substrate holding and rotating mechanism 611 includes a holding portion 612 having a plurality of stages 612a for clamping an outer circumferential portion of a wafer W, a rotational shaft 613 coupled to a lower portion of the holding portion 612, and a rotation drive mechanism (not shown) coupled to the rotational shaft 613. Thus, the substrate holding and rotating mechanism 611 serves to rotate the wafer W at a predetermined rotational speed. The substrate holding and rotating mechanism 611 has a switch mechanism (not shown) for opening and closing the stages 612a when the wafer W is transferred into and from the substrate holding and rotating mechanism 611.

The pencil-type cleaning mechanism 614 has a swing arm 616 supported at an end thereof by a shaft 615, a rotational shaft 617 extending vertically downward from the other end thereof toward an upper surface of the wafer W being cleaned, and a cleaning member 618 attached to a lower end of the rotational shaft 617. For example, the cleaning member 618 may be formed of a porous PVF sponge. Alternatively, the cleaning member 618 may be made of polyurethane foam. The shaft 615 can be vertically moved and rotated by a drive mechanism (not shown). When the shaft 615 is rotated, the swing arm 616 is swung. The cleaning member 618 can be moved between a cleaning position at which the cleaning member 618 is brought into contact with the upper surface of the wafer W and a retracting position at which the cleaning member 618 is spaced from the upper surface of the wafer W. Further, the cleaning member 618 is rotated during cleaning by rotation of the rotational shaft 617. The cleaning liquid supply nozzle 619 is configured to supply a cleaning liquid onto the upper surface of the wafer W. The spin-dry unit 610 may include an additional cleaning liquid supply nozzle (not shown) disposed below the wafer W for supplying a cleaning liquid onto the lower surface of the wafer W.

A cleaning and drying process is performed in the secondary cleaning and drying unit 610 as follows. When a wafer W is introduced into the secondary cleaning and drying unit 610, the substrate holding and rotating mechanism 611 holds the wafer W and rotates the wafer W at a low speed of about 100 to 500 rpm. Then, while a cleaning liquid is supplied from the cleaning liquid supply nozzle 619 onto the upper surface of the wafer W, the swing arm 616 is swung over the entire upper surface of the wafer W. Thus, the rotating cleaning member 618 is brought into contact with the upper surface of the wafer W and moved to scrub and clean the wafer W. After completion of the scrubbing, the swing arm 616 is moved to a standby position. Then, the rotational speed of the substrate holding and rotating mechanism 611 is increased to rotate the wafer W at a high speed of about 1500 to 5000 rpm, thereby spin-drying the wafer W. At that time, a clean inert gas may be supplied from a gas supply nozzle (not shown) during spin-drying as needed. In the present example, the cleaning member 618 is used for scrubbing. However, instead of the above scrubbing process, pure water to which ultrasonic vibration has been applied may be supplied from the cleaning liquid supply nozzle 619 for non-contact cleaning to remove particles attached to the surface of the wafer W.

### 10. Substrate Process Patterns

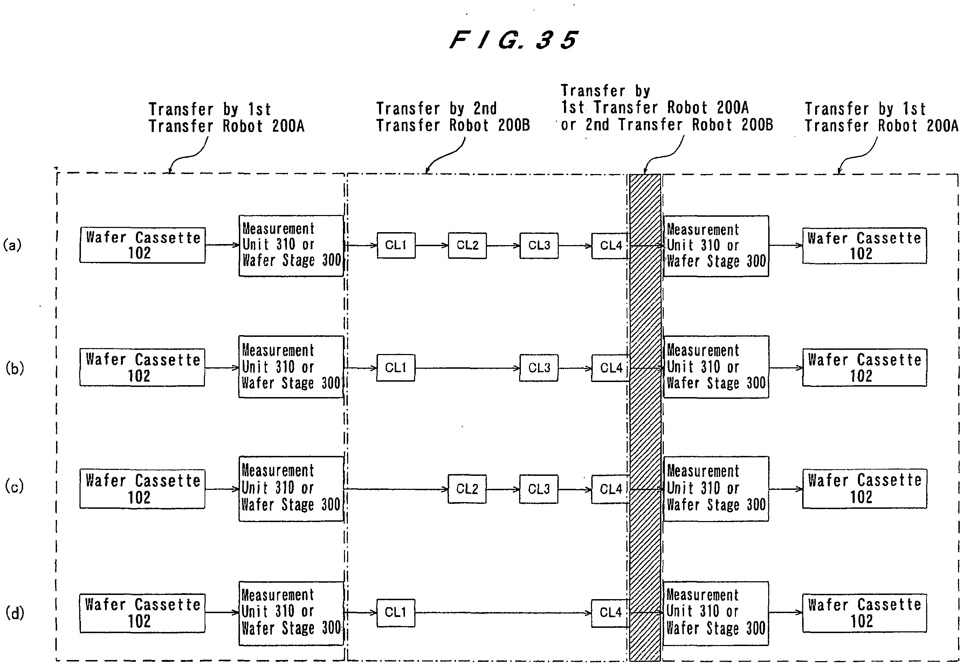

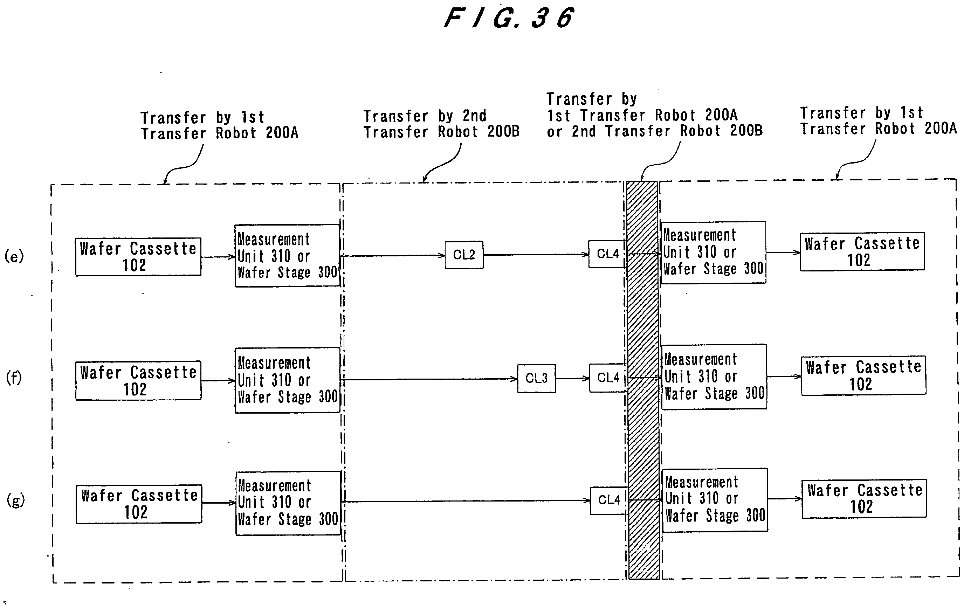

Next, process patterns of wafers in the substrate processing apparatus 1 will be described below. FIGS. 35 and 36 are diagrams explanatory of routes of wafers in several process patterns. In FIGS. 35 and 36, CL1, CL2, CL3, and CL4 represent the first polishing unit 400A, the second polishing unit 400B, the primary cleaning unit 600, and the secondary cleaning and drying unit 610, respectively. In a first process pattern (a), when a wafer cassette 102, which holds wafers after a CMP process or a Cu deposition process, is placed on the loading/unloading port 100, the first transfer robot 200A takes a wafer out of the wafer cassette 102 and transfers it to the measurement unit 310. In the measurement unit 310, necessary data on the diameter of the wafer, the cross-sectional shape of a peripheral portion of the wafer, and the surface conditions of the wafer are measured before polishing. If it is not necessary to measure the wafer before polishing, the wafer may be transferred to the wafer stage 300 instead of the measurement unit 310. The second transfer robot 200B transfers the measured wafer from the measurement unit 310 to the first polishing unit 400A. In the first polishing unit 400A, a peripheral portion (a bevel portion and a notch) of the wafer is polished. The second transfer robot 200B transfers the wafer polished in the first polishing unit 400A to the second polishing unit 400B, where the wafer is further polished. The second transfer robot 200B transfers the wafer polished in the second polishing unit 400B to the primary cleaning unit 600, where primary cleaning is conducted on the wafer. The second transfer robot 200B transfers the wafer cleaned in the primary cleaning unit 600 to the secondary cleaning and drying unit 610, where secondary cleaning and drying are conducted on the wafer. The first or second transfer robot 200A or 200B transfers the dried wafer to the measurement unit 310, where the processed wafer is measured. If it is not necessary to measure the processed wafer, the dried wafer is transferred from the secondary cleaning and drying unit 610 to the wafer stage 300. Then, the first transfer robot 200A transfers the wafer from the measurement unit 310 or the wafer stage 300 to the wafer cassette 102. Alternatively, the dried wafer is returned from the secondary cleaning and drying unit 610 directly to the wafer cassette 102 by the first transfer robot 200A.

The first process pattern is performed for serial processing in which the same wafer is polished sequentially in the first polishing unit 400A and the second polishing unit 400B. According to the serial processing, the first polishing unit 400A and the second polishing unit 400B can be used for respective purposes of polishing. For example, objects attached to a peripheral portion of a wafer or surface roughness of a wafer can be removed in the first polishing unit 400A, and then finish polishing can be conducted on the wafer in the second polishing unit 400B.

In a second process pattern (b), when a wafer cassette 102 is placed on the loading/unloading port 100, the first transfer robot 200A takes a wafer out of the wafer cassette 102 and transfers it to the measurement unit 310 or the wafer stage 300. If the wafer is transferred to the measurement unit 310, necessary data on the diameter of the wafer, the cross-sectional shape of a peripheral portion of the wafer, and the surface conditions of the wafer are measured before polishing. Then, the second transfer robot 200B transfers the wafer from the measurement unit 310 or the wafer stage 300 to the first polishing unit 400A. In the first polishing unit 400A, a peripheral portion (a bevel portion and a notch) of the wafer is polished. The second transfer robot 200B transfers the wafer polished in the first polishing unit 400A to the primary cleaning unit 600, where primary cleaning is conducted on the wafer. The second transfer robot 200B transfers the wafer cleaned in the primary cleaning unit 600 to the secondary cleaning and drying unit 610, where secondary cleaning and drying are conducted on the wafer. The dried wafer is transferred to the measurement unit 310 or the wafer stage 300 by the first or second transfer robot 200A or 200B and then returned to the wafer cassette 102 by the first transfer robot 200A. Alternatively, the dried wafer is returned from the secondary cleaning and drying unit 610 directly to the wafer cassette 102 by the first transfer robot 200A.

In a third process pattern (c), the second transfer robot 200B transfers the wafer to the second polishing unit 400B, instead of transferring the wafer from the measurement unit 310 or the wafer stage 300 to the first polishing unit 400A in the second process pattern (b). At that time, it is possible to conduct parallel processing. Specifically, while a wafer that has previously been transferred can be polished in the first polishing unit 400A according to the second process pattern (b), a next wafer can be transferred and polished in the second polishing unit 400B according to the third process pattern (c). According to parallel processing, in which different wafers are polished in parallel in the first polishing unit 400A and the second polishing unit 400B, the number of wafers processed per unit time can be increased to improve a throughput of the substrate processing apparatus 1. Thus, a rate of operation can be improved. When parallel processing is conducted, the polishing tapes having the same grain size are used in the first and second polishing units 400A and 400B. For example, such polishing tapes include a polishing tape having a grain size of #6000 to #8000.

In a fourth process pattern (d), the first transfer robot 200A takes a wafer out of the wafer cassette 102 and transfers it to the measurement unit 310 or the wafer stage 300. Then, the second transfer robot 200B transfers the wafer from the measurement unit 310 or the wafer stage 300 to the first polishing unit 400A. In the first polishing unit 400A, a peripheral portion (a bevel portion and a notch) of the wafer is polished. The second transfer robot 200B transfers the wafer polished in the first polishing unit 400A to the secondary cleaning and drying unit 610; where secondary cleaning and drying are conducted on the wafer. The dried wafer is transferred to the measurement unit 310 or the wafer stage 300 by the first or second transfer robot 200A or 200B and then returned to the wafer cassette 102 by the first transfer robot 200A. Alternatively, the dried wafer is returned from the secondary cleaning and drying unit 610 directly to the wafer cassette 102 by the first transfer robot 200A.

In a fifth process pattern (e), the second transfer robot 200B transfers the wafer to the second polishing unit 400B, instead of transferring the wafer from the measurement unit 310 or the wafer stage 300 to the first polishing unit 400A in the fourth process pattern (d). At that time, it is possible to conduct parallel processing. Specifically, while a wafer that has previously been transferred can be polished in the first polishing unit 400A according to the fourth process pattern (d), a next wafer can be transferred and polished in the second polishing unit 400B according to the fifth process pattern (e).

In a sixth process pattern (f), the first transfer robot 200A takes a wafer out of the wafer cassette 102 and transfers it to the measurement unit 310 or the wafer stage 300. Then, the second transfer robot 200B transfers the wafer to the primary cleaning unit 600, where primary cleaning is conducted on the wafer. The second transfer robot 200B transfers the wafer cleaned in the primary cleaning unit 600 to the secondary cleaning and drying unit 610, where secondary cleaning and drying are conducted on the wafer. The dried wafer is transferred to the measurement unit 310 or the wafer stage 300 by the first or second transfer robot 200A or 200B and then returned to the wafer cassette 102 by the first transfer robot 200A. Alternatively, the dried wafer is returned from the secondary cleaning and drying unit 610 directly to the wafer cassette 102 by the first transfer robot 200A.

In a seventh process pattern (g), the first transfer robot 200A takes a wafer out of the wafer cassette 102 and transfers it to the measurement unit 310 or the wafer stage 300. Then, the second transfer robot 200B transfers the wafer from the measurement unit 310 or the wafer stage 300 to the secondary cleaning and drying unit 610, where secondary cleaning and drying are conducted on the wafer. The dried wafer is transferred to the measurement unit 310 or the wafer stage 300 by the first or second transfer robot 200A or 200B and then returned to the wafer cassette 102 by the first transfer robot 200A. Alternatively, the dried wafer is returned from the secondary cleaning and drying unit 610 directly to the wafer cassette 102 by the first transfer robot 200A.

The substrate processing apparatus 1 can both conduct parallel processing and serial processing. The first and second polishing units 400A and 400B can be employed for the respective polishing purposes by properly selecting counts of polishing tapes used in the first and second polishing units 400A and 400B and operating conditions in the first and second polishing units 400A and 400B according to purposes of polishing wafers. Thus, optimal polishing processes can be performed on wafers. In the above process patterns, when the measurement unit 310 is occupied by a wafer that has previously been transferred, a next wafer may be placed temporarily on the wafer stage 300 for standby. In such a case, wafers can efficiently be transferred and processed.

When a wafer is measured twice, i.e., before and after polishing, even if the measurement unit 3 10 is occupied by a wafer measured before polishing, a wafer dried in the secondary cleaning and drying unit 610 can be placed temporarily on the wafer stage 300 for measurement after polishing because the substrate processing apparatus 1 has the wafer stage 300. Accordingly, the secondary cleaning and drying unit 610 can subsequently receive a next wafer and conduct secondary cleaning and drying on the next wafer. Thus, it is possible to improve a throughput of the substrate processing apparatus 1.

In the above process patterns, timing of transferring wafers may be adjusted depending upon required processing periods of time in the measurement unit 310, the first polishing unit 400A, the second polishing unit 400B, the primary cleaning unit 600, and the secondary cleaning and drying unit 610. In such a case, the wafers can smoothly be transferred and processed in the substrate processing apparatus 1 to further improve the throughput of the substrate processing apparatus 1.

Any shapes or materials that have not been directly described in the specification or illustrated in the drawings are encompassed by the scope of the present invention as long as they achieve the advantageous effects of the present invention. For example, in the above embodiments, the polishing unit includes the bevel polishing device and the notch polishing device for polishing a peripheral portion of a wafer. However, the substrate processing apparatus may have a chemical mechanical polishing (CMP) unit for pressing a surface of a wafer against a polishing surfaces of a polishing table onto which a polishing liquid is supplied. Further, in the above embodiments, the substrate processing apparatus has two polishing units. However, the substrate processing apparatus may have three or more polishing units.

Although certain preferred embodiments of the present invention have been shown and described in detail, it should be understood that various changes and modifications may be made therein without departing from the scope of the appended claims.

### Industrial Applicability

The present invention is suitable for use in a substrate processing apparatus having a polishing unit for polishing a peripheral portion of a substrate such as a semiconductor wafer.

## Claims

1. A substrate processing apparatus comprising:
at least two polishing units (400A, 400B), each of said two polishing units (400A, 400B) including at least one of a bevel polishing device (450) and a notch polishing device (480) for polishing a peripheral portion of a substrate;
a maintenance space (7) formed between said two polishing units (400A, 400B); and
an entrance (8) for allowing an operator to enter said maintenance space (7) from exterior of said substrate processing apparatus,
wherein said at least one of said bevel polishing device (450) and said notch polishing device (480) in each of said two polishing units (400A, 400B) faces said maintenance space (7) so as to be accessible from said maintenance space (7).

2. The substrate processing apparatus as recited in claim 1, wherein said each of said two polishing units (400A, 400B) is housed in a casing (403) having a hatch (407) provided at a position facing said maintenance space (7), wherein said at least one of said bevel polishing device (450) and said notch polishing device (480) in each of said two polishing units (400A, 400B) is accessible from the maintenance space (7) by opening said hatch (407).

3. The substrate processing apparatus as recited in claim 1 or 2, wherein said bevel polishing device (450) includes:
(i) a polishing tape (451),
(ii) a bevel polishing head (460) for pressing said polishing tape (451) against the peripheral portion of the substrate, and
(iii) a polishing tape supply/recovery mechanism (452) for supplying said polishing tape (451) to said bevel polishing head (460) and recovering said polishing tape (451) from said bevel polishing head (460), said polishing tape (451) in said polishing tape supply/recovery mechanism (452) being adapted to be replaced from said maintenance space (7),
wherein said notch polishing device (480) includes:
(i) a polishing tape (481),
(ii) a notch polishing head (490) for pressing said polishing tape (481) against a notch of the substrate, and
(iii) a polishing tape supply/recovery mechanism (482) for supplying said polishing tape (481) to said notch polishing head (490) and recovering said polishing tape (481) from said notch polishing head (490), said polishing tape (481) in said polishing tape supply/recovery mechanism (482) being adapted to be replaced from said maintenance space (7).

4. The substrate processing apparatus as recited in claim 2, wherein said casing (403) has sidewalls on four sides thereof,
wherein one of said bevel polishing device (450) and said notch polishing device (480) is disposed near a first of said sidewalls of said casing (403), said first of said sidewalls of said casing 8403) facing said maintenance space (7), wherein another of said bevel polishing device (450) and said notch polishing device (480) is disposed near a second of said sidewalls of said casing (403) which is adjacent to said first of said sidewalls of said casing (403), said second of said sidewalls of said casing (403) facing a housing (3) for said substrate processing apparatus.

5. The substrate processing apparatus as recited in claim 4, wherein said casing (403) has a hatch (408) provided in said second of said sidewalls thereof,
wherein said housing (3) for said substrate processing apparatus has a door (9) provided at a position facing said second of said sidewalls of said casing (403, wherein said substrate processing apparatus is configured such that said bevel polishing device (450) or said notch polishing device (480) is accessible from an exterior of said substrate processing apparatus when said door (9) of said housing (3) and said hatch (408) of said casing (403) are opened.

6. The substrate processing apparatus as recited in claim 4 or 5, further comprising a transfer device (200B) for transferring the substrate to and from said polishing units (400A, 400B),
wherein an opening (405) for introducing the substrate into said polishing unit (400A, 400B) is formed in a third of said sidewalls of said casing (403), said opening (405) facing said transfer device (200B),
wherein a shutter (405a) is provided for closing and opening said opening (405).

7. The substrate processing apparatus as recited in claim 1, wherein said bevel polishing devices (450) or said notch polishing devices (480) in said at least two polishing units (400A, 400B) are arranged so as to be symmetrical with interposing said maintenance space (7) therebetween.

8. The substrate processing apparatus as recited in claim 7, wherein operations of said bevel polishing devices (450) or said notch polishing devices (480) in said at least two polishing units (400A, 400B) are configured so as to be symmetrical with interposing said maintenance space (7) therebetween.

9. The substrate processing apparatus as recited in claim 1, wherein said polishing unit (400A, 400B) includes:
(i) a substrate holding table (411) for holding the substrate to be polished by said at least one of said bevel polishing device (450) and said notch polishing device (480), and
(ii) at least one of a swing mechanism (439) for swinging said substrate holding table (411) on a horizontal plane and a horizontal movement mechanism (423) for linearly moving said substrate holding table (411) on a horizontal plane.

10. The substrate processing apparatus as recited in claim 1, wherein said at least one of said bevel polishing device (450) and said notch polishing device (480) is configured so as to bring a surface of a polishing tape into sliding contact with the peripheral portion or a notch of the substrate to polish the substrate, wherein said polishing tape has a polishing layer in which a chemically inactive resin material into which abrasive particles are dispersed is applied to a surface of a tape base.

11. The substrate processing apparatus as recited in claim 10, wherein said polishing unit (400A, 400B) includes:
(i) a substrate holding device (410) for horizontally holding the substrate to be polished by said at least one of said bevel polishing device (450) and said notch polishing device (480),
(ii) a first supply nozzle (523, 524) for supplying at least one of pure water, ultrapure water, and deionized water toward a polishing area of the substrate held by said substrate holding device (410), and
(iii) a second supply nozzle (525) for supplying at least one of pure water, ultrapure water, and deionized water toward a central portion on an upper surface of the substrate.

## Patentansprüche

1. Substratbehandlungsvorrichtung, die folgendes aufweist:
wenigstens zwei Poliereinheiten (400A, 400B), wobei jede der zwei Poliereinheiten (400A, 400B) wenigstens eine Abschrägpoliervorrichtung (450) und/oder eine Kerbenpoliervorrichtung (480) aufweisen zum Polieren eines Umfangsteils eines Substrats;
einen Wartungsraum (7), der zwischen den zwei Poliereinheiten (400A, 400B) ausgebildet ist; und
einen Eingang (8), um einem Bediener zu erlauben, in den Wartungsraum (7) von außerhalb der Substratpoliervorrichtung einzutreten,
wobei die wenigstens eine Abschrägpoliervorrichtung (450) und/oder die Kerbenpoliervorrichtung (480) in jeder der zwei Poliereinheiten (400A, 400B) zu dem Wartungsraum (7) weist, um von dem Wartungsraum (7) aus erreichbar zu sein.

2. Substratbehandlungsvorrichtung nach Anspruch 1, wobei jede der zwei Poliereinheiten (400A, 400B) in einem Gehäuse (403) aufgenommen ist, das eine Klappe (407) aufweist, die an einer zum Wartungsraum (7) weisenden Position vorgesehen ist, wobei die Abschrägpoliervorrichtung (450) und/oder die Kerbenpoliervorrichtung (480) in den zwei Poliereinheiten (400A, 400B) durch Öffnen der Klappe (407) aus dem Wartungsraum (7) heraus erreichbar ist/sind.

3. Poliervorrichtung nach einem der Ansprüche 1 oder 2, wobei die Abschrägpoliervorrichtung (450) folgendes aufweist:
(i) ein Polierband (451)
(ii) einen Abschrägpolierkopf (460) zum Drücken des Polierbandes (451) gegen den Umfangsteil des Substrats, und
(iii) einen Polierbandliefer-/rückholmechanismus (452) zum Liefern des Polierbandes (451) an den Abschrägpolierkopf und zum Rückholen des Polierbandes (451) von dem Abschrägpolierkopf (460), wobei das Polierband (451) in dem Polierbandliefer-/rückholmechanismus (452) in der Lage ist von dem Wartungsraum (7) aus ersetzt zu werden,
wobei die Kerbenpoliervorrichtung (480) folgendes aufweist:
(i) ein Polierband (481),
(ii) einen Kerbenpolierkopf (490) zum Drücken des Polierbandes (481) gegen eine Kerbe des Substrats, und
(iii) einen Polierbandliefer-/rückholmechanismus (482) zum Liefern des Polierbandes (481) an den Kerbenpolierkopf (490) und Zurückholen des Polierbandes (481) von dem Kerbenpolierkopf (490), wobei das Polierband (481) in dem Polierbandliefer-/rückholmechanismus (482) in der Lage ist vom Wartungsraum (7) aus ersetzt zu werden.

4. Substratsbehandlungsvorrichtung nach Anspruch 2, wobei das Gehäuse (403) Seitenwände an vier Seiten davon aufweist,
wobei die Abschrägpoliervorrichtung (450) oder die Kerbenpoliervorrichtung (480) in der Nähe einer ersten der Seitenwände des Gehäuses (403) angeordnet ist, wobei die erste der Seitenwände des Gehäuses (403) zu dem Wartungsraum (7) weist, wobei die andere Vorrichtung, das heißt die Kerbenpoliervorrichtung (480) oder die Abschrägpoliervorrichtung (450) in der Nähe einer zweiten der Seitenwände des Gehäuses (403) angeordnet ist, die benachbart zu der ersten der Seitenwände des Gehäuses (403) angeordnet ist, wobei die zweite der Seitenwände des Gehäuses (403) zu einem Gehäuse (3) der Substratbehandlungsvorrichtung weist.

5. Substratbehandlungsvorrichtung nach Anspruch 4, wobei das Gehäuse (403) eine Klappe (408) aufweist, die an der zweiten der Seitenwände davon vorgesehen ist, wobei das Gehäuse (3) für die Substratbehandlungsvorrichtung eine Tür (9) aufweist, die an einer Position vorgesehen ist, die zur zweiten der Seitenwände des Gehäuses (403) weist, wobei die Substratbehandlungsvorrichtung derart konfiguriert ist, dass auf die Abschrägpoliervorrichtung (450) oder die Kerbenpoliervorrichtung (480) von außerhalb der Substratbehandlungsvorrichtung zugegriffen werden kann, wenn die Tür (9) des Gehäuses (3) und die Klappe (408) des Gehäuses (403) geöffnet sind.

6. Substratbehandlungsvorrichtung nach Anspruch 4 oder 5, die ferner folgendes aufweist:
eine Transfervorrichtung (200B) zum Übertragen des Substrats zu und von den Poliereinheiten (400A, 400B), wobei eine Öffnung (405) zum Einführen der Substrate in die Poliereinheit (400A, 400B) in einer dritten der Seitenwände des Gehäuses (403) ausgebildet ist, wobei die Öffnung (405) zu der Transfervorrichtung (200B) weist, wobei ein Schließelement vorgesehen ist zum Schließen und Öffnen der Öffnung (405).

7. Substratbehandlungsvorrichtung nach Anspruch 1, wobei die Abschrägpoliervorrichtung (450) oder die Kerbenpoliervorrichtungen (480) in den wenigstens zwei Poliereinheiten (400A, 400B) bezüglich des dazwischenliegenden Wartungsraums (7) symmetrisch angeordnet sind.

8. Substratbehandlungsvorrichtung nach Anspruch 7, wobei der Betrieb der Abschrägpoliervorrichtungen (450) oder der Kerbenpoliervorrichtungen (480) in den wenigstens zwei Poliereinheiten (400A, 400B) so konfiguriert sind, dass sie symmetrisch sind mit dem dazwischen liegenden Wartungsraum (7).

9. Substratbehandlungsvorrichtung nach Anspruch 1, wobei die Poliereinheiten (400A, 400B) folgendes aufweisen:
(i) einen Substrathaltetisch (411) zum Halten des durch die wenigstens eine Abschrägpoliervorrichtung (450) und/oder die Kerbenpoliervorrichtung (480) zu polierenden Substrats, und
(ii) einen Schwenkmechanismus (439) zum Schwenken des Substrathaltetischs (411) in einer Horizontalebene und/oder einen Horizontalbewegungsmechanismus (423) zum linearen Bewegen des Substrathaltetischs (411) in einer horizontalen Ebene.

10. Substratbehandlungsvorrichtung nach Anspruch 1, wobei die Abschrägpoliervorrichtung (450) und/oder die Kerbenpoliervorrichtung (480) derart konfiguriert ist/sind, dass sie eine Oberfläche eines Polierbandes in Gleitkontakt mit dem Umfangsteil oder einer Kerbe des Substrats bringt, um das Substrat zu polieren, wobei das Polierband eine Polierschicht aus einem chemisch inaktiven Harzmaterial aufweist in dem abrasive Partikel dispergiert sind, und das auf einer Oberfläche eines Grundbandes aufgebracht ist.

11. Substratbehandlungsvorrichtung nach Anspruch 10, wobei die Poliereinheit (400A, 400B) folgendes aufweist:
(i) eine Substrathaltevorrichtung (410) zum horizontalen Halten des durch die Abschrägpoliervorrichtung (450) und/oder die Kerbenpoliervorrichtung (480) zu polierenden Substrats,
(ii) eine erste Lieferdüse (423, 424) zum Liefern von reinem Wasser und/oder ultrareinem Wasser und/oder deionisiertem Wasser zu einem Polierbereich des Substrates, das durch die Substrathaltevorrichtung (410) gehalten wird, und
(iii) eine zweite Lieferdüse (525) zum Liefern von reinem Wasser und/oder ultrareinem Wasser und/oder deionisiertem Wasser zu einem Mittelteil auf einer Oberseite des Substrats.

## Revendications

1. Appareil de traitement de substrat comprenant :
au moins deux unités de polissage (400A, 400B), chacune desdites deux unités de polissage (400A, 400B) comprenant au moins un dispositif parmi un dispositif de polissage de biseau (450) et un dispositif de polissage d'entaille (480) destiné à polir une partie périphérique d'un substrat ;
un espace de maintenance (7) formé entre lesdites deux unités de polissage (400A, 400B) ; et
une entrée (8) destinée à permettre à un opérateur de pénétrer dans ledit espace de maintenance (7) à partir de l'extérieur dudit appareil de traitement de substrat ;
dans lequel ledit au moins un dispositif parmi ledit dispositif de polissage de biseau (450) et ledit dispositif de polissage d'entaille (480) dans chacune desdites deux unités de polissage (400A, 400B), fait face audit espace de maintenance (7) de façon à être accessible à partir dudit espace de maintenance (7).

2. Appareil de traitement de substrat selon la revendication 1, dans lequel chacune desdites deux unités de polissage (400A, 400B) est logée dans un boîtier (403) qui présente une trappe (407) disposée au niveau d'une position qui fait face audit espace de maintenance (7), dans lequel ledit au moins un dispositif parmi ledit dispositif de polissage de biseau (450) et ledit dispositif de polissage d'entaille (480) dans chacune desdites deux unités de polissage (400A, 400B) est accessible à partir de l'espace de maintenance (7) en ouvrant ladite trappe (407).

3. Appareil de traitement de substrat selon la revendication 1 ou 2, dans lequel ledit dispositif de polissage de biseau (450) comprend :
(i) une bande de polissage (451) ;
(ii) une tête de polissage de biseau (460) destinée à presser ladite bande de polissage (451) contre la partie périphérique du substrat ; et
(iii) un mécanisme de fourniture / de récupération de bande de polissage (452) destiné à fournir ladite bande de polissage (451) à ladite tête de polissage de biseau (460) et à récupérer ladite bande de polissage (451) à partir de ladite tête de polissage de biseau (460), ladite bande de polissage (451) dans ledit mécanisme de fourniture / de récupération de bande de polissage (452) étant adaptée pour être remplacée à partir dudit espace de maintenance (7) ;
dans lequel ledit dispositif de polissage d'entaille (480) comprend :
(i) une bande de polissage (481) ;
(ii) une tête de polissage d'entaille (490) destinée à presser ladite bande de polissage (481) contre une entaille du substrat ; et
(iii) un mécanisme de fourniture / de récupération de bande de polissage (482) destiné à fournir ladite bande de polissage (481) à ladite tête de polissage d'entaille (490) et à récupérer ladite bande de polissage (481) à partir de ladite tête de polissage d'entaille (490), ladite bande de polissage (481) dans ledit mécanisme de fourniture / de récupération de bande de polissage (482) étant adaptée pour être remplacée à partir dudit espace de maintenance (7).

4. Appareil de traitement de substrat selon la revendication 2, dans lequel ledit boîtier (403) présente des parois latérales sur quatre côtés de celui-ci ;
dans lequel un dispositif parmi ledit dispositif de polissage de biseau (450) et ledit dispositif de polissage d'entaille (480) est disposé à proximité d'une première paroi parmi lesdites parois latérales dudit boîtier (403), ladite première paroi parmi lesdites parois latérales dudit boîtier (403) faisant face audit espace de maintenance (7), dans lequel l'autre dispositif parmi ledit dispositif de polissage de biseau (450) et ledit dispositif de polissage d'entaille (480) est disposé à proximité d'une deuxième paroi parmi lesdites parois latérales dudit boîtier (403) qui est adjacente à ladite première paroi parmi lesdites parois latérales dudit boîtier (403), ladite deuxième paroi parmi lesdites parois latérales dudit boîtier (403) faisant face à un logement (3) dudit appareil de traitement de substrat.

5. Appareil de traitement de substrat selon la revendication 4, dans lequel ledit boîtier (403) présente une trappe (408) disposée dans ladite deuxième paroi parmi lesdites parois latérales de celui-ci, dans lequel ledit logement (3) pour ledit appareil de traitement de substrat présente une porte (9) disposée au niveau d'une position qui fait face à ladite deuxième paroi parmi lesdites parois latérales dudit boîtier (403), dans lequel ledit appareil de traitement de substrat est configuré de telle sorte que ledit dispositif de polissage de biseau (450) ou que ledit dispositif de polissage d'entaille (480) soit accessible à partir de l'extérieur dudit appareil de traitement de substrat lorsque ladite porte (9) dudit logement (3) et ladite trappe (408) dudit boîtier (403) sont ouvertes.

6. Appareil de traitement de substrat selon la revendication 4 ou 5, comprenant en outre un dispositif de transfert (200B) destiné à transférer le substrat vers lesdites unités de polissage (400A, 400B) et à partir de celles-ci ;
dans lequel une ouverture (405) destinée à introduire le substrat dans ladite unité de polissage (400A, 400B) est formée dans une troisième paroi parmi lesdites parois latérales dudit boîtier (403), ladite ouverture (405) faisant face audit dispositif de transfert (200B) ;
dans lequel un volet d'obturation (405a) est prévu pour fermer et ouvrir ladite ouverture (405).

7. Appareil de traitement de substrat selon la revendication 1, dans lequel lesdits dispositifs de polissage de biseau (450) ou lesdits dispositifs de polissage d'entaille (480) dans lesdites au moins deux unités de polissage (400A, 400B), sont agencés de façon à être symétriques en interposant entre eux ledit espace de maintenance (7).

8. Appareil de traitement de substrat selon la revendication 7, dans lequel les opérations desdits dispositifs de polissage de biseau (450) ou desdits dispositifs de polissage d'entaille (480) dans lesdites au moins deux unités de polissage (400A, 400B), sont configurées de façon à être symétriques en interposant entre eux ledit espace de maintenance (7).

9. Appareil de traitement de substrat selon la revendication 1, dans lequel ladite unité de polissage (400A, 400B) comprend :
(i) une table de retenue de substrat (411) destinée à retenir le substrat à polir au moyen dudit au moins un dispositif parmi ledit dispositif de polissage de biseau (450) et ledit dispositif de polissage d'entaille (480) ; et
(ii) au moins un mécanisme parmi un mécanisme de pivotement (439) destiné à faire pivoter ladite table de retenue de substrat (411) dans un plan horizontal et un mécanisme de déplacement horizontal (423) destiné à déplacer de manière linéaire ladite table de retenue de substrat (411) dans un plan horizontal.

10. Appareil de traitement de substrat selon la revendication 1, dans lequel ledit au moins un dispositif parmi ledit dispositif de polissage de biseau (450) et ledit dispositif de polissage d'entaille (480) est configuré de façon à amener une surface d'une bande de polissage en contact glissant avec la partie périphérique ou une entaille du substrat pour polir le substrat, dans lequel ladite bande de polissage présente une couche de polissage dans laquelle un matériau à base de résine, chimiquement inactif, dans lequel sont dispersées des particules abrasives, est appliqué à une surface d'un support de bande.

11. Appareil de traitement de substrat selon la revendication 10, dans lequel ladite unité de polissage (400A, 400B) comprend :
(i) un dispositif de retenue de substrat (410) destiné à retenir de manière horizontale le substrat à polir au moyen dudit au moins un dispositif parmi ledit dispositif de polissage de biseau (450) et ledit dispositif de polissage d'entaille (480) ;
(ii) une première buse d'alimentation (523, 524) destinée à fournir au moins un type d'eau parmi de l'eau pure, de l'eau ultra-pure, et de l'eau déminéralisée vers une zone de polissage du substrat retenu par ledit dispositif de retenue de substrat (410) ; et
(iii) une seconde buse d'alimentation (525) destinée à fournir au moins un type d'eau parmi de l'eau pure, de l'eau ultra-pure et de l'eau déminéralisée à une partie centrale située sur une surface supérieure du substrat.
